# EUROPEAN PATENT APPLICATION

(11) **EP 4 216 696 A1**
(43) Date of publication of application: **26.07.2023**
(21) Application number: 22217232.2
(22) Date of filing: 29.12.2022
(51) Int. Cl.: H10K 85/60, H10K 50/15

(54) **LIGHT-EMITTING DEVICE AND ELECTRONIC APPARATUS INCLUDING THE SAME**

(30) Priority: 31.12.2021 KR 20210194248; 11.02.2022 KR 20220018470
(71) Applicant: Samsung Display Co., Ltd., Yongin-si, Gyeonggi-do 17113 (KR); Merck Patent GmbH, 64293 Darmstadt (DE)
(72) Inventor: KIM, Mikyung, 17113 Yongin-si (KR); MONTENEGRO, Elvira, 64293 Darmstadt (DE); ENGELHART, Jens, 64293 Darmstadt (DE); EICKHOFF, Christian, 64293 Darmstadt (DE); NA, Suhwan, 64293 Darmstadt (DE); KIM, Hyerim, 17113 Yongin-si (KR); SEO, Jihyun, 17113 Yongin-si (KR); SHIN, Hyunsu, 17113 Yongin-si (KR); JANG, Hanbyul, 17113 Yongin-si (KR)
(74) Representative: Marks & Clerk LLP

(57) **Abstract**

The present invention relates to a light-emitting device and an electronic apparatus including the light-emitting device. The light-emitting device includes a first electrode, a second electrode facing the first electrode, and an interlayer between the first electrode and the second electrode and including an emission layer, wherein: the interlayer further includes a hole transport region between the emission layer and the first electrode, the hole transport region includes a first layer and a second layer, the second layer being between the first layer and the emission layer, the first layer includes a first amine-based compound, the second layer includes a second amine-based compound, and the first amine-based compound and the second amine-based compound are different from each other.

## Description

### BACKGROUND

### 1. Field

One or more embodiments of the present disclosure relate to a light-emitting device and an electronic apparatus including the same.

### 2. Description of the Related Art

From among light-emitting devices, self-emissive devices have wide viewing angles, high contrast ratios, short response times, and excellent characteristics in terms of luminance, driving voltage, and response speed.

In a light-emitting device, a first electrode is on a substrate, and a hole transport region, an emission layer, an electron transport region, and a second electrode are sequentially on the first electrode. Holes provided from the first electrode move toward the emission layer through the hole transport region, and electrons provided from the second electrode move toward the emission layer through the electron transport region. Carriers, such as holes and electrons, recombine in the emission layer to produce excitons. These excitons transition from an excited state to a ground state to thereby generate light.

### SUMMARY

One or more embodiments of the present disclosure include a light-emitting device having a low driving voltage, high light-emission efficiency, and a long lifespan.

Additional aspects of embodiments will be set forth in part in the description, which follows and, in part, will be apparent from the description, or may be learned by practice of the presented embodiments of the present disclosure.

According to one or more embodiments, provided is a light-emitting device including a first electrode,
a second electrode facing the first electrode, and
an interlayer between the first electrode and the second electrode and including an emission layer, wherein:
the interlayer may further include a hole transport region between the emission layer and the first electrode,
the hole transport region may include a first layer and a second layer, the second layer being between the first layer and the emission layer,
the first layer may include a first amine-based compound,
the second layer may include a second amine-based compound,
the first amine-based compound and the second amine-based compound may be different from each other, and
at least one selected from Conditions 1-1 to 1-3 may be satisfied.

### Condition 1-1

The first amine-based compound includes two or more fluorene moieties.

### Condition 1-2

The second amine-based compound includes two or more fluorene moieties.

### Condition 1-3

The first amine-based compound and the second amine-based compound each include two or more fluorene moieties.

According to one or more embodiments, provided is an electronic apparatus including the light-emitting device.

At least some of the above and other features of the invention are set out in the claims.

### BRIEF DESCRIPTION OF THE DRAWINGS

The above and other aspects and features of certain embodiments of the present disclosure will be more apparent from the following description taken in conjunction with the accompanying drawings, in which:
FIG. 1 is a schematic cross-sectional view of a light-emitting device according to an embodiment; and
FIGS. 2 and 3 are each a cross-sectional view of a light-emitting apparatus according to an embodiment.

### DETAILED DESCRIPTION

Reference will now be made in more detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects of embodiments of the present description. As used herein, the term "and/or" includes any and all combinations of one or more of the associated listed items. Throughout the present disclosure, the expression "at least one of a, b and c" indicates only a, only b, only c, both a and b, both a and c, both b and c, all of a, b, and c, or variations thereof.

The subject matter of the present disclosure may include various modifications and various embodiments, and example embodiments will be illustrated in the drawings and described in more detail in the detailed description. Effects and features of the subject matter of the present disclosure, and implementation methods therefor will become clear with reference to the embodiments described herein below together with the drawings. The subject matter of the present disclosure may, however, be embodied in many different forms and should not be construed as limited to the embodiments set forth herein.

Hereinafter, embodiments of the present disclosure will be described in more detail with reference to the accompanying drawings. The same or corresponding elements will be denoted by the same reference numerals, and thus, redundant description thereof will not be repeated.

It will be understood that although the terms "first," "second," etc. may be used herein to describe various elements, these elements should not be limited by these terms. These terms are only used to distinguish one element from another.

An expression used in the singular encompasses the expression of the plural, unless it has a clearly different meaning in the context.

In the following embodiments, it is to be understood that the terms such as "including," "having," and "comprising" are intended to indicate the existence of the features or elements disclosed in the specification, and are not intended to preclude the possibility that one or more other features or elements may exist or may be added.

In the following embodiments, when various elements such as layers, films, regions, plates, etc. are said to be "on" another element, this may include not only a case in which these various elements are "immediately on" the layers, films, regions, or plates, but also a case in which other elements may be placed therebetween. Sizes of elements in the drawings may be exaggerated for convenience of explanation. In other words, because sizes and thicknesses of elements in the drawings may be arbitrarily illustrated for convenience of explanation, the following embodiments are not limited thereto.

The term "interlayer," as used herein, refers to a single layer and/or all of a plurality of layers between a first electrode and a second electrode of a light-emitting device.

The expression "C consists of D," as used herein, refers to a case in which a region C is composed only of any compound belonging to the category of a compound D, or any combination thereof. Accordingly, when C consists of D, any compound not belonging to the category of the compound D may not be included in the region C.

The term "fluorene moiety," as used herein, refers to a moiety including two or more cyclic groups (for example, a C₅-C₆₀ carbocyclic group or a C₁-C₆₀ heterocyclic group) condensed to cyclopentane, wherein substituents of some carbons constituting the cyclopentane may be bonded to each other to form a spiro-structure, together with the carbons to which the substituents are bonded. For example, the fluorene moiety may refer to a group represented by Formula A or a group represented by Formula B.

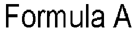

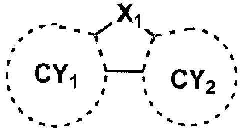

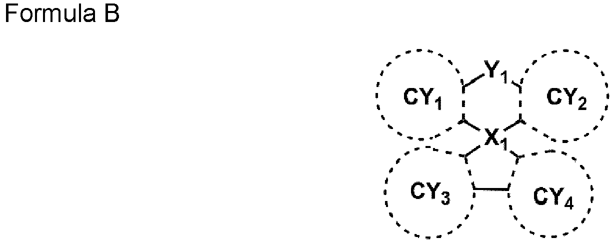

Formulae A and B will be described in more detail herein below.

In addition, when a particular compound includes two or more of the fluorene moiety, it may be understood that "the particular compound includes two or more fluorene moieties of an identical type (or kind) or different types (or kinds)."

For example, the expression "Compound 1 includes two fluorene moieties" may include i) a case in which Compound 1 includes two identical fluorene moieties represented by Formula A, ii) a case in which Compound 1 includes two different fluorene moieties represented by Formula A, iii) a case in which Compound 1 includes two identical fluorene moieties represented by Formula B, iv) a case in which Compound 1 includes two different fluorene moieties represented by Formula B, and v) a case in which Compound 1 includes a fluorene moiety represented by Formula A and a fluorene moiety represented by Formula B, where the fluorene moiety represented by Formula A is different from the fluorene moiety represented by Formula B.

Herein, a lowest excitation triplet energy level (T₁) and a highest occupied molecular orbital (HOMO) energy level are provided by quantum-chemical calculations, performed utilizing the Gaussian program package (Gaussian16, available from Gaussian Inc.). The singlet ground state geometries are optimized utilizing the B3LYP hybrid functional and the 6-31 G(d) basis set (a B3LYP/6-31 G(d) level of theory). Subsequently, time-dependent density functional theory (TD-DFT) singlet and triplet excitation energies (vertical transitions) are computed using the optimized ground state geometry and the same level of theory (B3LYP/6-31 G(d)). Default settings for self-consistent field (SCF) and geometry convergence are employed.

According to one or more embodiments, provided is a light-emitting device including: a first electrode;
a second electrode facing the first electrode; and
an interlayer between the first electrode and the second electrode and including an emission layer, wherein:
the interlayer may further include a hole transport region between the emission layer and the first electrode,
the hole transport region may include a first layer and a second layer, the second layer being between the first layer and the emission layer,
the first layer may include a first amine-based compound,
the second layer may include a second amine-based compound,
the first amine-based compound and the second amine-based compound may be different from each other, and
at least one selected from Conditions 1-1 to 1-3 may be satisfied:

### Condition 1-1

the first amine-based compound includes two or more fluorene moieties;

### Condition 1-2

the second amine-based compound includes two or more fluorene moieties; and

### Condition 1-3

the first amine-based compound and the second amine-based compound each include two or more fluorene moieties.

For example, the first amine-based compound and the second amine-based compound may satisfy: i) only Condition 1-1; ii) only Condition 1-2; or iii) all of Conditions 1-1, 1-2, and 1-3.

In an embodiment, the first amine-based compound and the second amine-based compound may satisfy Condition 1-2; or Conditions 1-2 and 1-3.

In an embodiment, the first amine-based compound and the second amine-based compound may satisfy at least one selected from Condition 1-2a and Condition 1-3a:

### Condition 1-2a

the second amine-based compound includes two or more fluorene moieties attached via their respective 4-positions; and

### Condition 1-3a

the first amine-based compound and the second amine-based compound each include two or more fluorene moieties attached via their respective 4-positions.

In an embodiment, the two or more fluorene moieties may be identical to or different from each other. For more details, related descriptions provided above may be referred to.

In an embodiment, in the light-emitting device, the first electrode may be an anode,
the second electrode may be a cathode,
the interlayer may further include an electron transport region between the emission layer and the second electrode,
the hole transport region may include a hole injection layer, a hole transport layer, an emission auxiliary layer, an electron blocking layer, or any combination thereof, and
the electron transport region may include a buffer layer, a hole blocking layer, an electron control layer, an electron transport layer, an electron injection layer, or any combination thereof.

In an embodiment, the hole transport region may further include a hole transport layer, and
the hole transport layer may be in direct contact (e.g., physical contact) with the first layer.

In an embodiment, the hole transport layer may not include a p-dopant. The p-dopant will be described in more detail herein below.

In an embodiment, the first layer may be in direct contact (e.g., physical contact) with the second layer.

In an embodiment, the second layer may be in direct contact (e.g., physical contact) with the emission layer.

In an embodiment, the emission layer may include a phosphorescent dopant. The phosphorescent dopant will be described in more detail herein below.

In an embodiment, the emission layer may emit green light.

In an embodiment, the emission layer may emit light having a maximum emission wavelength range of about 500 nm to about 600 nm, or about 500 nm to about 550 nm.

In an embodiment, the first layer may consist of the first amine-based compound.

In an embodiment, the second layer may consist of the second amine-based compound.

In an embodiment, a thickness of the first layer may be greater than a thickness of the second layer.

In an embodiment, a thickness ratio of the first layer to the second layer may be in a range of about 5:5 to about 10:1, for example about 5:1 to about 10:1, or about 5:5 to about 9:1.

In an embodiment, the thickness of the first layer may be about 10 nm or more and about 50 nm or less, for example, about 15 nm or more and about 40 nm or less.

In an embodiment, the thickness of the second layer may be about 0.1 nm or more and about 20 nm or less, for example, about 0.5 nm or more and about 15 nm or less.

In an embodiment, a lowest excitation triplet energy level of the first amine-based compound determined by quantum chemical calculation, as described above, may be less than about 2.70 eV, for example, less than about 2.68 eV, about 2.40 or more and less than about 2.70 eV; or about 2.50 eV or more and less than about 2.68 eV.
In an embodiment, a lowest excitation triplet energy level of the second amine-based compound determined by quantum chemical calculation, as described above, may be about 2.65 eV or more, for example, about 2.65 eV or more and about 3.00 eV or less; or about 2.70 eV or more and about 3.00 eV or less.

In an embodiment, a HOMO energy level of the first amine-based compound determined by quantum chemical calculation, as described above may be about -4.50 eV or less, for example, about -5.10 eV or more and about -4.50 eV or less or about - 5.00 eV or more and about -4.50 eV or less.

In an embodiment, a HOMO energy level of the second amine-based compound determined by quantum chemical calculation, as described above may be about -4.50 eV or less, for example, about -5.20 eV or more and about -4.50 eV or less, or about -5.10 eV or more and about -4.90 eV or less.

In an embodiment, the fluorene moiety may be a group represented by Formula A or a group represented by Formula B: 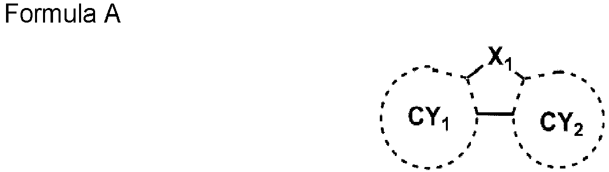 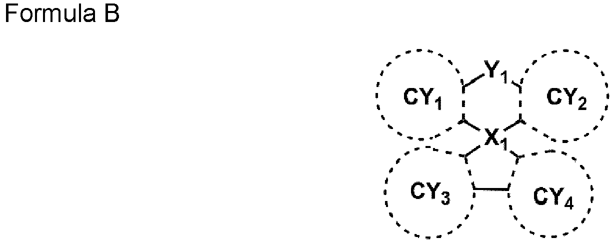
wherein, in Formulae A and B,
CY₁ to CY₄ may each independently be a C₅-C₆₀ (e.g. C₅-C₃₀) carbocyclic group or a C₁-C₆₀ *(e.*g*.* C₁-C₂₀) heterocyclic group,
X₁ may be a group including C, and
Y₁ may be a non-bond, a single bond, O, or S.

For example, Y₁ in Formula B may be a single bond.

The term "group including C" as used herein, refers a C atom or a C atom connected to hydrogen or another substituent. For example, X₁ in Formula A may be a C atom connected to hydrogen or another substituent (i.e. C(R₁₃)(R₁₄), wherein R₁₃ and R₁₄ maybe each the same as described herein).

The term "non-bond," as used herein, refers to a case in which two atoms connected to Y₁ are not bonded to each other, wherein each atom may be connected to hydrogen or another substituent. For example, Y₁ may be a non-bond such that Y₁ is absent and does not form a ring between CY₁ and CY₂.

The term "single bond," as used herein, refers to a case in which two atoms connected to Y₁ are directly bonded to each other through a single bond. Accordingly, when Y₁ is a single bond, CY₁ and CY₂ in Formula B may be bonded to each other through a single bond.

In an embodiment, the fluorene moiety may be substituted or unsubstituted.

For example, the fluorene moiety may be substituted by phenyl group, but the present disclosure is not limited thereto.

In an embodiment, the first amine-based compound and the second amine-based compound may both include the fluorene moiety. For example, the first amine-based compound may include one or more fluorene moieties, the second amine-based compound may also include one or more fluorene moieties, and the fluorene moieties of the first amine-based compound and the fluorene moieties of the second amine-based compound may be identical to or different from each other.

In an embodiment, the first amine-based compound may be represented by Formula 1, and
the second amine-based compound may be represented by Formula 2: 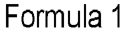 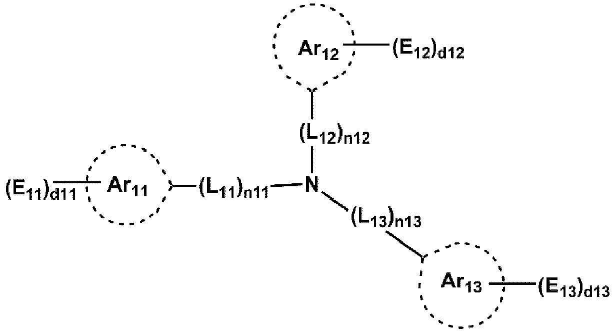 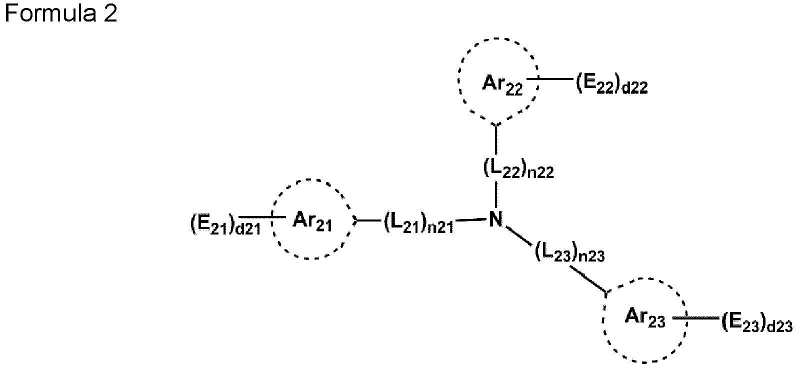 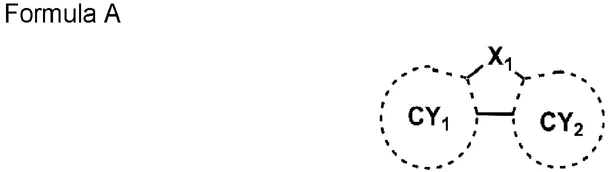 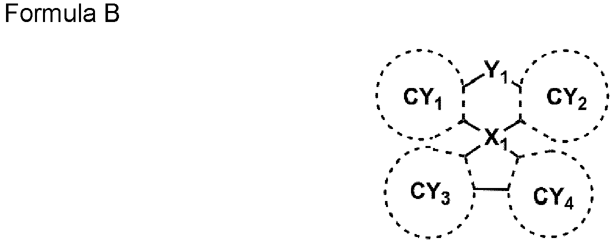 wherein, in Formulae 1 and 2,
Ar₁₁ and Ar₂₁ may each independently be a group represented by Formula A or a group represented by Formula B,
Ar₁₂, Ar₁₃, Ar₂₂, and Ar₂₃ may each independently be a C₅-C₆₀ (*e.g.* C₅-C₃₀) carbocyclic group, a C₁-C₆₀ (*e.g.* C₁-C₂₀) heterocyclic group, a group represented by Formula A, or a group represented by Formula B,
at least one selected from Ar₁₂ and Ar₂₂ may be a group represented by Formula A or a group represented by Formula B,
L₁₁ to L₁₃ and L₂₁ to L₂₃ may each independently be a single bond, a C₅-C₆₀ (*e.g.* C₅-C₃₀) carbocyclic group unsubstituted or substituted with at least one R₁₀ₐ, or a C₁-C₆₀ (*e.g.* C₁-C₂₀) heterocyclic group unsubstituted or substituted with at least one R₁₀ₐ,
n11 to n13 and n21 to n23 may each independently be an integer selected from 1 to 3,
E₁₁ to E₁₃ and E₂₁ to E₂₃ may each independently be hydrogen, deuterium, - F, -Cl, -Br, -I, a hydroxyl group, a cyano group, a nitro group, a C₁-C₆₀ (*e.g.* C₁-C₂₀) alkyl group unsubstituted or substituted with at least one P₁₀ₐ, a C₂-C₆₀ (*e.g.* C₂-C₂₀) alkenyl group unsubstituted or substituted with at least one P₁₀ₐ, a C₂-C₆₀ (*e.g.* C₂-C₂₀) alkynyl group unsubstituted or substituted with at least one P₁₀ₐ, a C₁-C₆₀ (*e.g.* C₁-C₂₀) alkoxy group unsubstituted or substituted with at least one P₁₀ₐ, a C₃-C₆₀ (*e.g.* C₃-C₃₀) carbocyclic group unsubstituted or substituted with at least one P₁₀ₐ, a C₁-C₆₀ (*e.g.* C₁-C₂₀) heterocyclic group unsubstituted or substituted with at least one P₁₀ₐ, a C₆-C₆₀ (*e.g.* C₆-C₃₀) aryloxy group unsubstituted or substituted with at least one P₁₀ₐ, a C₆-C₆₀ (*e.g.* C₆-C₃₀) arylthio group unsubstituted or substituted with at least one P₁₀ₐ, - Si(Q₁)(Q₂)(Q₃), -B(Q₁)(Q₂), -C(=O)(Q₁), -S(=O)₂(Q₁), or -P(=O)(Q₁)(Q₂),
d11 to d13 and d21 to d23 may each independently be an integer selected from 0 to 10, and
wherein, in Formulae A and B,
CY₁ to CY₄, X₁, and Y₁ are the same as described herein.

R₁₀ₐ may be:
deuterium, -F, -Cl, -Br, -I, a hydroxyl group, a cyano group, or a nitro group;
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, or a C₁-C₆₀ (*e.g.* C₁-C₂₀) alkoxy group, each unsubstituted or substituted with deuterium, -F, -Cl, -Br, -I, a hydroxyl group, a cyano group, a nitro group, a C₃-C₆₀(*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, a C₇-C₆₀ (*e.g.* C₇-C₃₀) aryl alkyl group, a C₂-C₆₀ (*e.g.* C₂-C₂₀) heteroaryl alkyl group, -Si(Q₁₁₎(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or any combination thereof;
a C₃-C₆₀(*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (*e.g.* C₆-C₃₀) arylthio group, a C₇-C₆₀ (*e.g.* C₇-C₃₀) aryl alkyl group, or a C₂-C₆₀ (*e.g.* C₂-C₂₀) heteroaryl alkyl group, each unsubstituted or substituted with deuterium, -F, -Cl, -Br, -I, a hydroxyl group, a cyano group, a nitro group, a C₁-C₆₀ (e.g. C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₆₀(*e.g.* C₃-C₃₀) carbocyclic group, a C₁-C₆₀ (*e.g.* C₁-C₂₀) heterocyclic group, a C₆-C₆₀ (*e.g.* C₆-C₃₀) aryloxy group, a C₆-C₆₀ (e.g. C₆-C₃₀) arylthio group, a C₇-C₆₀ (*e.g.* C₇-C₃₀) aryl alkyl group, a C₂-C₆₀ (e.g. C₂-C₂₀) heteroaryl alkyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ may each independently be: hydrogen; deuterium; -F; -Cl; -Br; -I; a hydroxyl group; a cyano group; a nitro group; a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₆₀ (*e.g.* C₃-C₃₀) carbocyclic group, or a C₁-C₆₀ (*e.g.* C₁-C₂₀) heterocyclic group, each unsubstituted or substituted with deuterium, -F, a cyano group, a C₁-C₆₀ (*e.g.* C₁-C₂₀) alkyl group, a C₁-C₆₀ (*e.g.* C₁-C₂₀) alkoxy group, a C₃-C₆₀ (*e.g.* C₃-C₃₀) carbocyclic group, a C₁-C₆₀ (*e.g.* C₁-C₂₀) heterocyclic group, a biphenyl group, or any combination thereof; a C₇-C₆₀ (*e.g.* C₇-C₃₀) arylalkyl group; or a C₂-C₆₀ (*e.g.* C₂-C₂₀) heteroarylalkyl group.

In an embodiment, the first amine-based compound and the second amine-based compound may satisfy one selected from Conditions 2-1 to 2-3:

### Condition 2-1

Ar₁₂ is a group represented by Formula A or a group represented by Formula B;

### Condition 2-2

Ar₂₂ is a group represented by Formula A or a group represented by Formula B; and

### Condition 2-3

Ar₁₂ and Ar₂₂ are each a group represented by Formula A or a group represented by Formula B.

For example, the first amine-based compound and the second amine-based compound may satisfy: i) only Condition 2-1; ii) only Condition 2-2; or iii) all of Conditions 2-1, 2-2, and 2-3.

In an embodiment, the first amine-based compound and the second amine-based compound may satisfy Condition 2-2; or Conditions 2-2 and 2-3.

In an embodiment, the group represented by Formula A may be a group represented by Formula A-1, and the group represented by Formula B may be a group represented by Formula B-1: 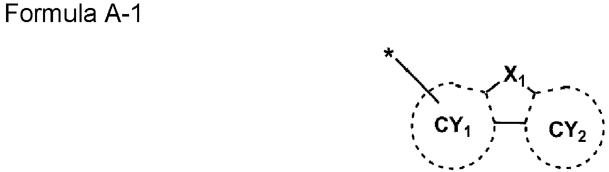 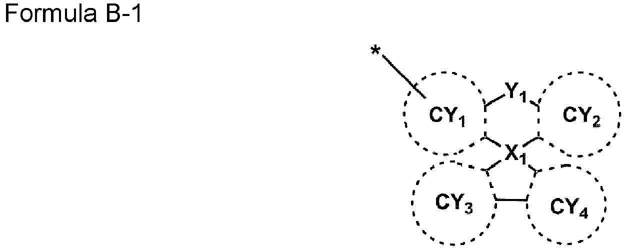 wherein, in Formulae A-1 and B-1,
CY₁ to CY₄, X₁, and Y₁ are the same as described herein, and
* indicates a binding site to a neighboring atom.

In an embodiment, the group represented by Formula A may be a group represented by one selected from Formulae A-1-1 to A-1-4, and
the group represented by Formula B may be a group represented by one selected from Formulae B-1-1 to B-1-4: 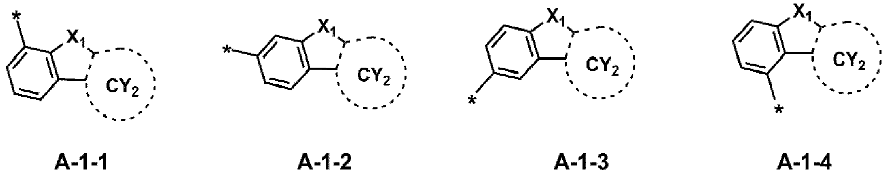 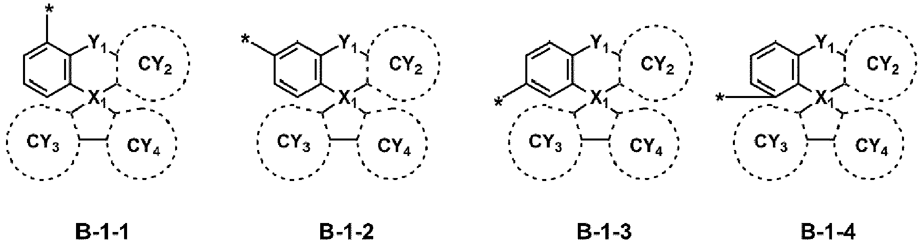 wherein, in Formulae A-1-1 to A-1-4 and B-1-1 to B-1-4,
CY₂ to CY₄, X₁, and Y₁ are each the same as described herein, and
* indicates a binding site to a neighboring atom.

In an embodiment, in Formula 2, Ar₂₁ may be a group represented by Formula A-1-4 or a group represented by Formula B-1-1; and Ar₂₂ may be a group represented by Formula A-1-4 or a group represented by Formula B-1-1, and the Formula A-1-4 and the Formula B-1-1 are each the same as described herein.

In an embodiment, L₁₁ to L₁₃ and L₂₁ to L₂₃ may each independently be: a single bond; or
a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a spiro-bifluorene group, a spiro[fluorene-9,9'-xanthene] group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a xanthene group, a pyridazine group, a triazine group, a quinoline group, an isoquinoline group, a quinoxaline group, a quinazoline group, a phenanthroline group, a pyrrole group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, a benzotriazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group, each unsubstituted or substituted with at least one R₁₀ₐ.

For example, L₁₁, L₁₂, and L₂₁ to L₂₃ in Formulae 1 and 2 may each be a single bond.

In an embodiment, in Formula 1, L₁₃ may be a C₅-C₆₀ (*e.g.* C₅-C₃₀) carbocyclic group unsubstituted or substituted with at least one R₁₀ₐ, n13 may be 1, and R₁₀ₐ is the same as described herein.

In an embodiment, a moiety represented by 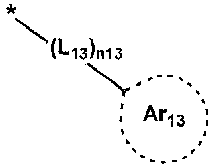 in Formula 1 may be represented by one selected from Formulae 3-1 to 3-3: 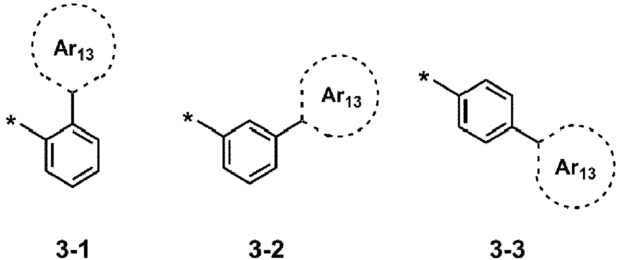 wherein, in Formulae 3-1 to 3-3,
Ar₁₃ is the same as described herein, and
* indicates a binding site to a neighboring atom.

In an embodiment, Ar₁₁ in Formula 1 may be a group represented by Formula A.

In an embodiment, the first amine-based compound may be represented by Formula 1-1: 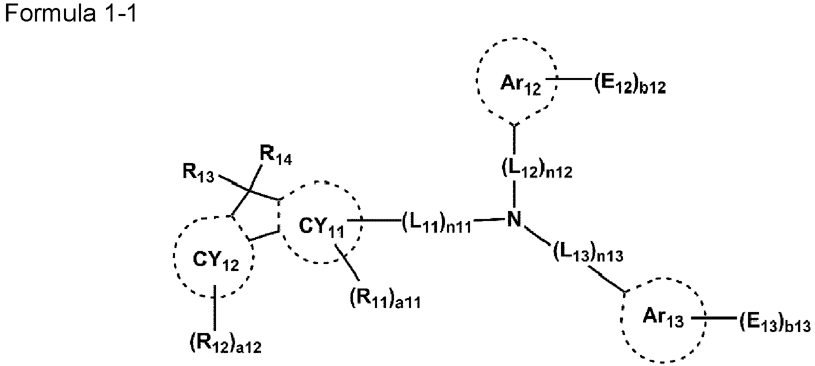 wherein, in Formula 1-1,
CY₁₁ is the same as described in connection with CY₁,
CY₁₂ is the same as described in connection with CY₂,
R₁₁ to R₁₄ are each the same as described in connection with E₁₁,
a11 may be an integer selected from 0 to 10,
a12 may be an integer selected from 0 to 10, and
Ar₁₂, Ar₁₃, L₁₁ to L₁₃, n11 to n13, E₁₂, E₁₃, b12, and b13 are each the same as described herein.

In an embodiment, Ar₂₁ in Formula 2 may be a group represented by Formula B.

In an embodiment, the second amine-based compound may be represented by Formula 2-1: 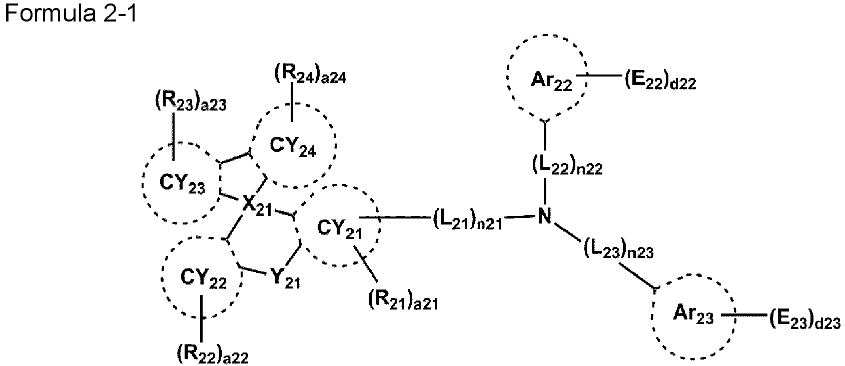 wherein, in Formula 2-1,
X₂₁ may be C,
CY₂₁ is the same as described in connection with CY₁,
CY₂₂ is the same as described in connection with CY₂,
CY₂₃ is the same as described in connection with CY₃,
CY₂₄ is the same as described in connection with CY₄,
Y₂₁ is the same as described in connection with Y₁,
R₂₁ to R₂₄ are each the same as described in connection with E₂₁,
a21 to a24 may each independently be an integer selected from 0 to 10, and
Ar₂₂, Ar₂₃, L₂₁ to L₂₃, n21 to n23, E₂₂, E₂₃, d22, and d23 are each the same as described herein.

In an embodiment, CY₁ to CY₄ in Formulae A and B may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a spiro-bifluorene group, a spiro[fluorene-9,9'-xanthene] group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a xanthene group, a pyridazine group, a triazine group, a quinoline group, an isoquinoline group, a quinoxaline group, a quinazoline group, a phenanthroline group, a pyrrole group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, a benzotriazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In an embodiment, Ar₁₂, Ar₁₃, Ar₂₂, and Ar₂₃ in Formulae 1 and 2 may each independently be: a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a spiro-bifluorene group, a spiro[fluorene-9,9'-xanthene] group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a xanthene group, a pyridazine group, a triazine group, a quinoline group, an isoquinoline group, a quinoxaline group, a quinazoline group, a phenanthroline group, a pyrrole group, a pyrazole group, an imidazole group, a triazole group, a tetrazole group, an oxazole group, an isoxazole group, a thiazole group, an isothiazole group, an oxadiazole group, a thiadiazole group, a benzopyrazole group, a benzimidazole group, a benzotriazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group; or
a group represented by Formula A or a group represented by Formula B.

In an embodiment, in Formula 2-1, a moiety represented by 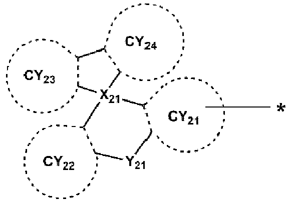 may be represented by Formula B-2-1, and A₂₂ may be represented by Formula A-1-4 or Formula B-1-1.

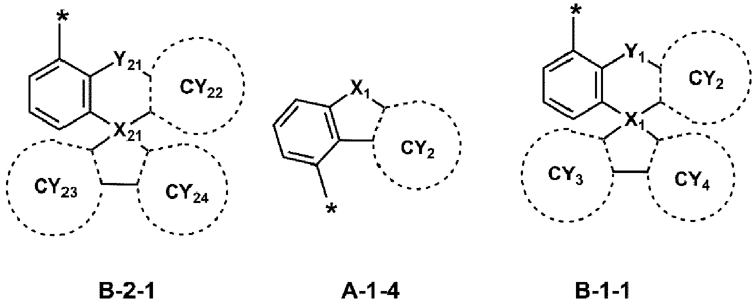

In Formula B-2-1, Formula A-1-4 and Formula B-1-1,
CY₂₂ to CY₂₄, CY₂ to CY₄, X₂₁, Y₂₁, X₁ and Y₁ are each the same as described herein.

In an embodiment, Ar₁₂, Ar₁₃, Ar₂₂ and/or Ar₂₃ may not include a carbazole group.

In an embodiment, the first amine-based compound and the second amine-based compound may each be one selected from Compounds 1-1 to 1-4, 2-1, and 2-2, but embodiments of the present disclosure are not limited thereto:

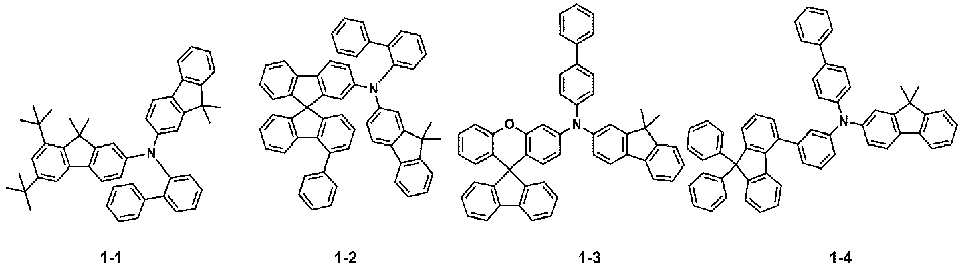

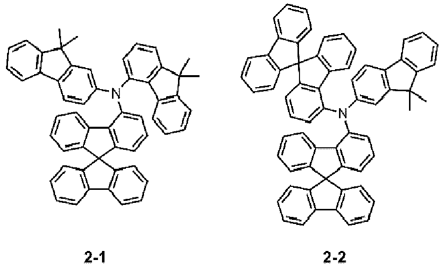

For example, the first amine-based compound may be one selected from Compounds 1-1 to 1-4, and the second amine-based compound may be one selected from Compounds 2-1 and 2-2, but embodiments of the present disclosure are not limited thereto.

The hole transport region of the present light-emitting device has a structure including a first layer and a second layer, the second layer being between the first layer and the emission layer. The first layer includes a first amine-based compound, the second layer includes a second amine-based compound, at least one selected from the first amine-based compound and the second amine-based compound includes two or more fluorene moieties, and the first amine-based compound and the second amine-based compound are different from each other.

Because at least one selected from the first amine-based compound and the second amine-based compound includes two or more fluorene moieties, the injection of holes in the emission layer is delayed to adjust the barrier between the hole transport layer and the emission layer, and thus, the exciton concentration in the emission layer may be reduced, thereby providing a light-emitting device having a long lifespan.

In addition, because the first amine-based compound and the second amine-based compound are different from each other, the hole movement speed in the hole transport region may be controlled, and thus, the exciton concentration and distribution in the emission layer may be effectively controlled.

Thus, by including the first layer and the second layer together, the light-emitting device of the present disclosure may concurrently (e.g., simultaneously) have high hole injection capability and hole transport capability, and thus may have a low driving voltage, excellent light-emission efficiency, and an excellent lifespan.

The expression "(a first layer) includes a first amine-based compound represented by Formula 1," as used herein, may include a case in which "(a first layer) includes identical first amine-based compounds represented by Formula 1" and a case in which "(a first layer) includes two or more different first amine-based compounds represented by Formula 1."

For example, the first layer may include, as the first amine-based compound, only Compound 1-1. In this regard, Compound 1-1 may be present in the first layer of the light-emitting device. In one or more embodiments, the first layer may include, as the first amine-based compound, Compound 1-1 and Compound 1-2.

The term "interlayer," as used herein, refers to a single layer and/or all of a plurality of layers between the first electrode and the second electrode of the light-emitting device.

According to one or more embodiments, provided is an electronic apparatus including the light-emitting device.

In an embodiment, the electronic apparatus may further include a thin-film transistor. For example, the electronic apparatus may further include a thin-film transistor including a source electrode and a drain electrode, and the first electrode of the light-emitting device may be electrically connected to the source electrode or the drain electrode.

In an embodiment, the electronic apparatus may further include a color filter, a color conversion layer, a touch screen layer, a polarizing layer, or any combination thereof. For example, the electronic apparatus may be a flat panel display apparatus, but embodiments of the present disclosure are not limited thereto.

For more details on the electronic apparatus, related descriptions provided herein may be referred to.

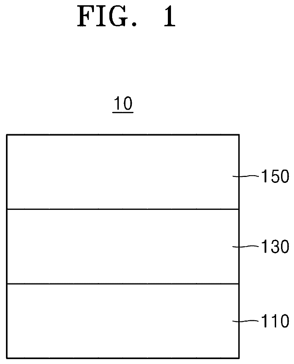

### Description of FIG. 1

FIG. 1 is a schematic cross-sectional view of a light-emitting device 10 according to an embodiment. The light-emitting device 10 includes a first electrode 110, an interlayer 130, and a second electrode 150.

Hereinafter, a structure of the light-emitting device 10 according to an embodiment and a method of manufacturing the light-emitting device 10 will be described with reference to FIG. 1.

### First electrode 110

In FIG. 1, a substrate may be additionally under the first electrode 110 or above the second electrode 150. As the substrate, a glass substrate and/or a plastic substrate may be used. In one or more embodiments, the substrate may be a flexible substrate, and may include plastics having excellent heat resistance and durability, such as polyimide, polyethylene terephthalate (PET), polycarbonate, polyethylene naphthalate, polyarylate (PAR), polyetherimide, or any combination thereof.

The first electrode 110 may be formed by, for example, depositing and/or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide (SnO₂), zinc oxide (ZnO), or any combination thereof. In one or more embodiments, when the first electrode 110 is a semi-transmissive electrode or a reflective electrode, a material for forming the first electrode 110 may include magnesium (Mg), silver (Ag), aluminium (Al), aluminium-lithium (Al-Li), calcium (Ca), magnesium-indium (Mg-In), magnesium-silver (Mg-Ag), or any combination thereof.

The first electrode 110 may have a single-layered structure consisting of a single layer or a multi-layered structure including a plurality of layers. For example, the first electrode 110 may have a three-layered structure of ITO/Ag/ITO.

### Interlayer 130

The interlayer 130 may be on the first electrode 110. The interlayer 130 includes an emission layer.

The interlayer 130 may further include a hole transport region between the first electrode 110 and the emission layer and an electron transport region between the emission layer and the second electrode 150.

The interlayer 130 may further include, in addition to various suitable organic materials, a metal-containing compound such as an organometallic compound, an inorganic material such as quantum dots, and/or the like.

In one or more embodiments, the interlayer 130 may include, i) two or more emitting units sequentially stacked between the first electrode 110 and the second electrode 150, and ii) a charge generation layer between the two or more emitting units. When the interlayer 130 includes the emitting units and the charge generation layer as described above, the light-emitting device 10 may be a tandem light-emitting device.

### Hole transport region in interlayer 130

The hole transport region may include the first layer and the second layer as described above.

The hole transport region may further include a hole injection layer, a hole transport layer, an emission auxiliary layer, an electron blocking layer, or any combination thereof.

For example, the hole transport region may further include a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein layers of each structure are stacked sequentially between the first electrode 110 and the first layer.

The hole transport region may include a compound represented by Formula 201, a compound represented by Formula 202, or any combination thereof: 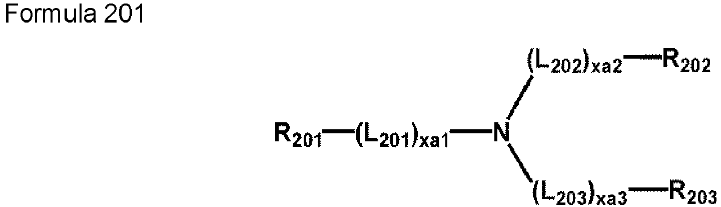 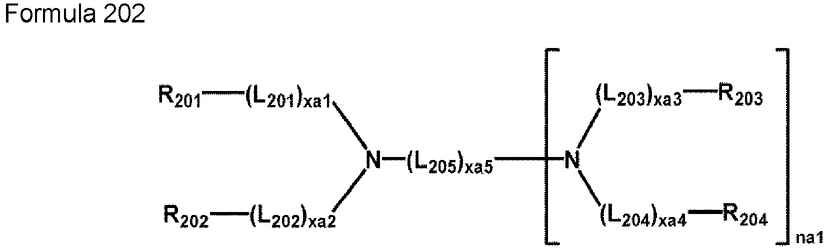 wherein, in Formulae 201 and 202,
L₂₀₁ to L₂₀₄ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
L₂₀₅ may be *-O-*', *-S-*', *-N(Q₂₀₁)-*', a C₁-C₂₀ (*e.g.* C₁-C₁₀) alkylene group unsubstituted or substituted with at least one R₁₀ₐ, a C₂-C₂₀ (*e.g.* C₂-C₁₀) alkenylene group unsubstituted or substituted with at least one R₁₀ₐ, a C₃-C₆₀ (*e.g.* C₃-C₃₀) carbocyclic group unsubstituted or substituted with at least one R₁₀ₐ, or a C₁-C₆₀ (*e.g.* C₁-C₂₀) heterocyclic group unsubstituted or substituted with at least one R₁₀ₐ,
xa1 to xa4 may each independently be an integer selected from 0 to 5,
xa5 may be an integer selected from 1 to 10,
R₂₀₁ to R₂₀₄ and Q₂₀₁ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
R₂₀₁ and R₂₀₂ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ (*e.g.* C₈-C₃₀) polycyclic group (for example, a carbazole group, etc.) unsubstituted or substituted with at least one R₁₀ₐ (for example, Compound HT16),
R₂₀₃ and R₂₀₄ may optionally be linked to each other via a single bond, a C₁-C₅ alkylene group unsubstituted or substituted with at least one R₁₀ₐ, or a C₂-C₅ alkenylene group unsubstituted or substituted with at least one R₁₀ₐ, to form a C₈-C₆₀ (*e.g.* C₈-C₃₀) polycyclic group unsubstituted or substituted with at least one R₁₀ₐ, and
na1 may be an integer selected from 1 to 4.

For example, each of Formulae 201 and 202 may include at least one selected from groups represented by Formulae CY201 to CY217: 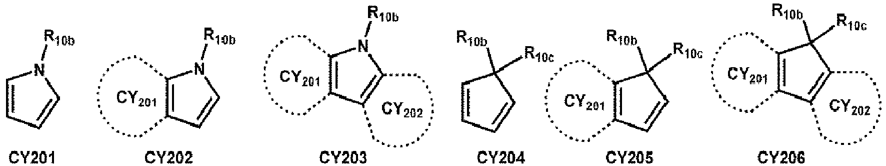 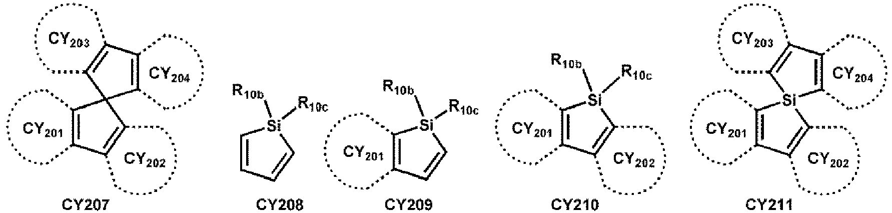 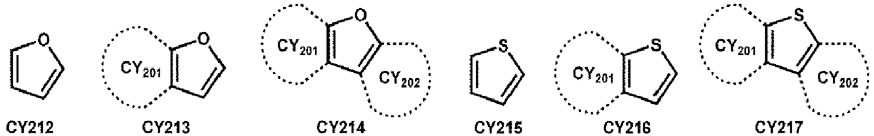 wherein, in Formulae CY201 to CY217, R_{10b} and R_{10c} are each the same as described in connection with R₁₀ₐ, ring CY₂₀₁ to ring CY₂₀₄ may each independently be a C₃-C₂₀ carbocyclic group or a C₁-C₂₀ heterocyclic group, and at least one hydrogen in Formulae CY201 to CY217 may be unsubstituted or substituted with R₁₀ₐ as described herein.

In an embodiment, in Formulae CY201 to CY217, ring CY₂₀₁ to ring CY₂₀₄ may each independently be a benzene group, a naphthalene group, a phenanthrene group, or an anthracene group.

In one or more embodiments, each of Formulae 201 and 202 may include at least one selected from groups represented by Formulae CY201 to CY203.

In one or more embodiments, Formula 201 may include at least one selected from the groups represented by Formulae CY201 to CY203 and at least one selected from the groups represented by Formulae CY204 to CY217.

In one or more embodiments, in Formula 201, xa1 may be 1, R₂₀₁ may be a group represented by one selected from Formulae CY201 to CY203, xa2 may be 0, and R₂₀₂ may be a group represented by one selected from Formulae CY204 to CY207.

In one or more embodiments, each of Formulae 201 and 202 may not include a group represented by one selected from Formulae CY201 to CY203.

In one or more embodiments, each of Formulae 201 and 202 may not include a group represented by one selected from Formulae CY201 to CY203, and may include at least one selected from the groups represented by Formulae CY204 to CY217.

In one or more embodiments, each of Formulae 201 and 202 may not include a group represented by one selected from Formulae CY201 to CY217.

For example, the hole transport region may include one of Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), or any combination thereof:

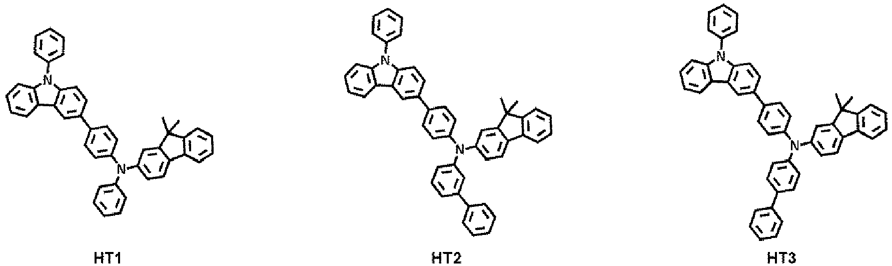

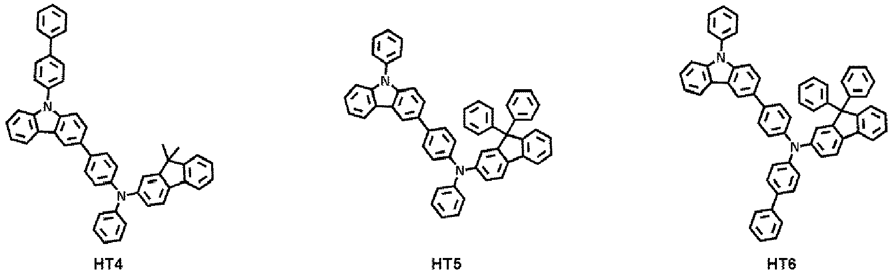

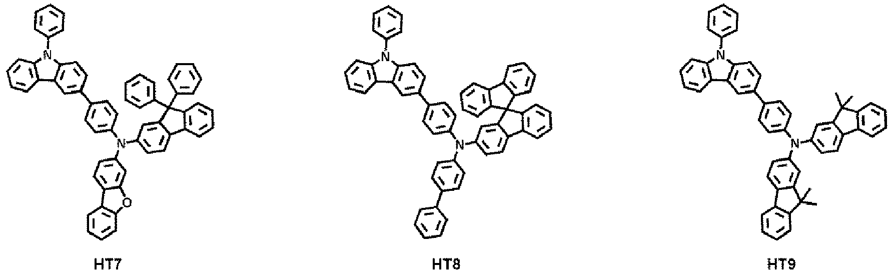

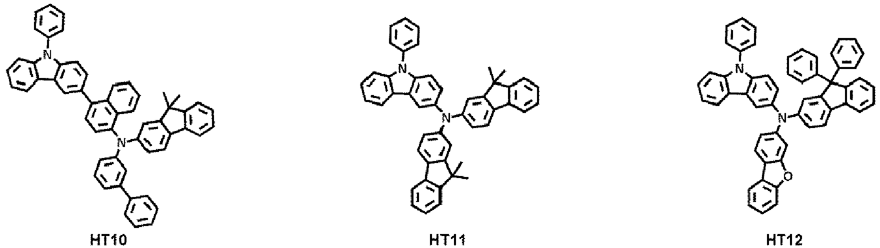

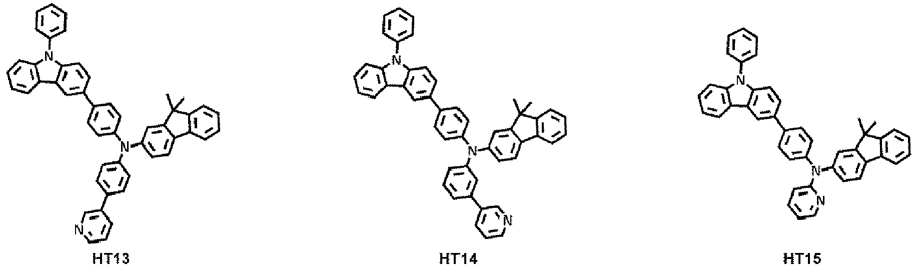

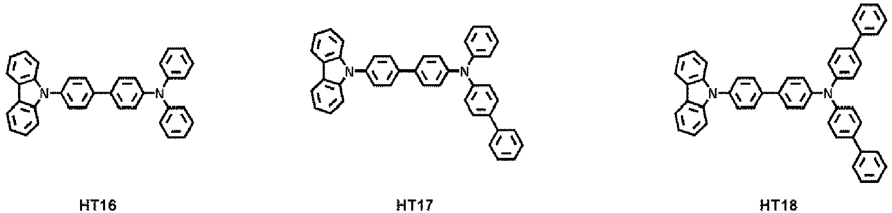

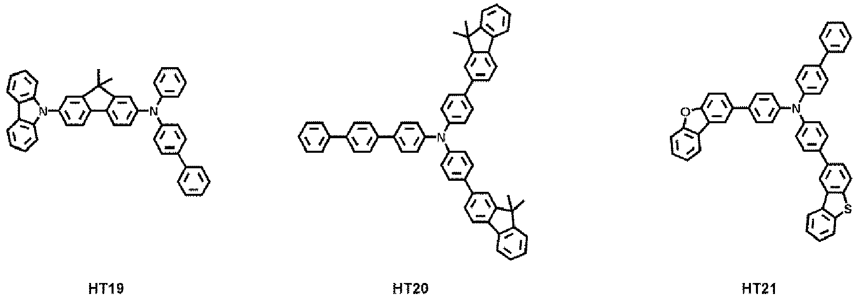

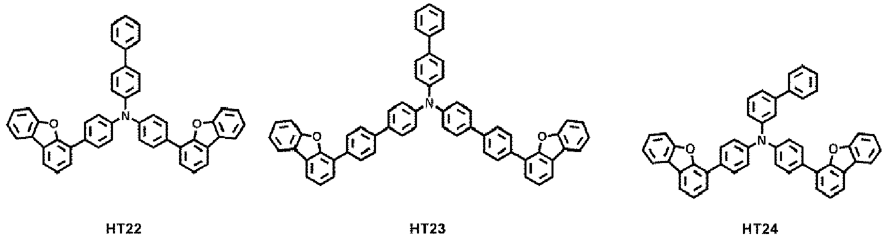

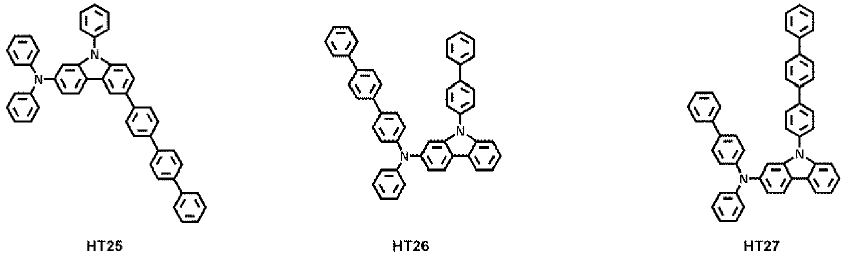

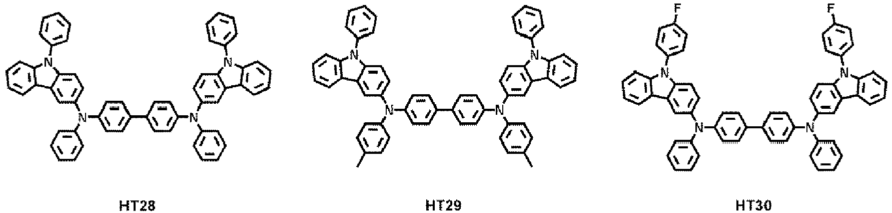

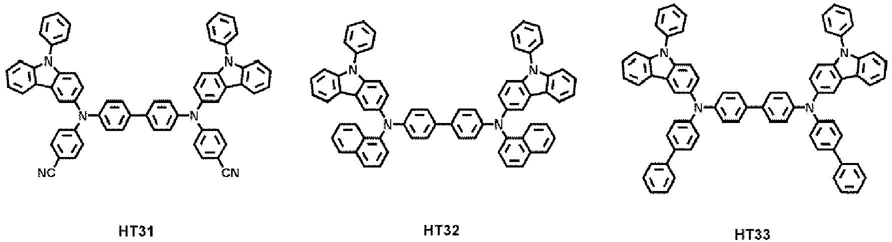

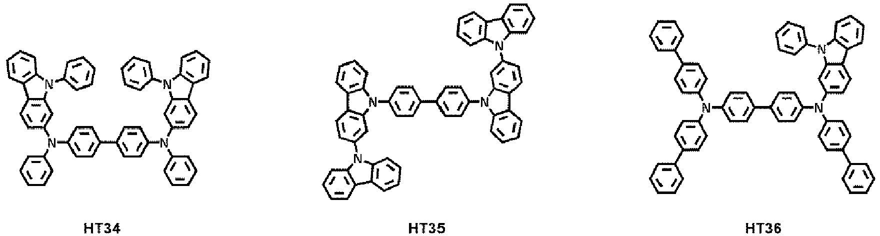

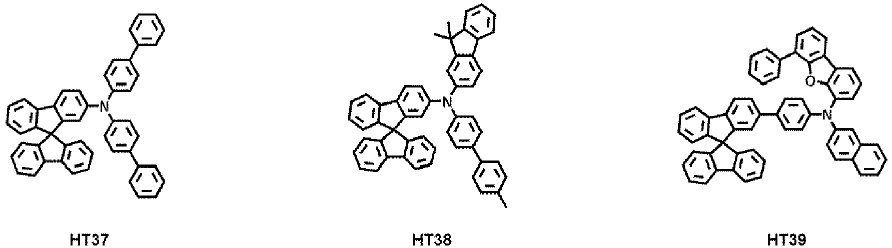

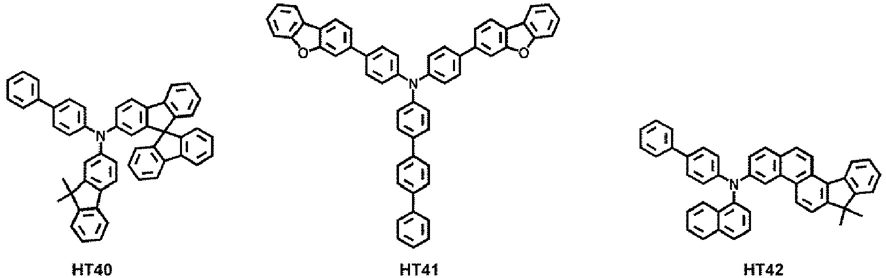

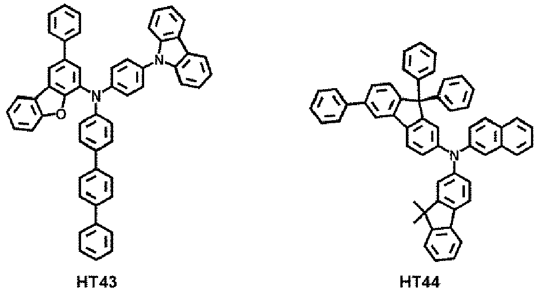

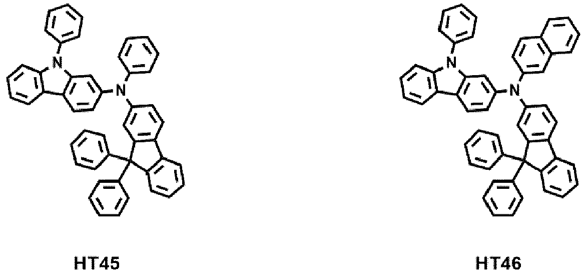

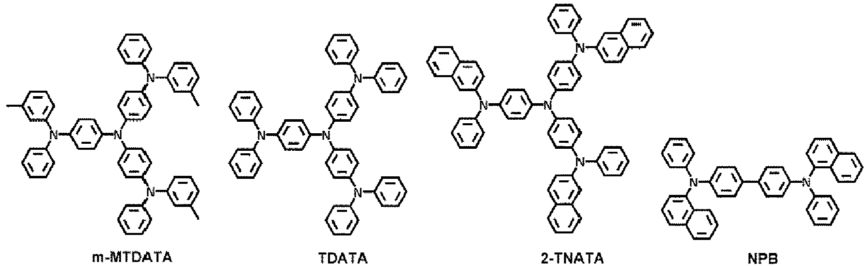

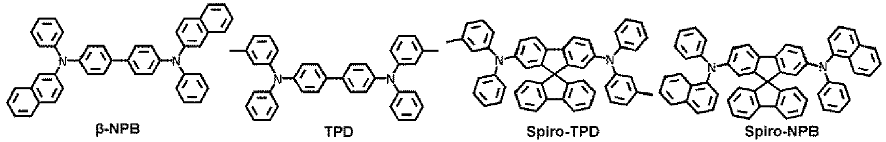

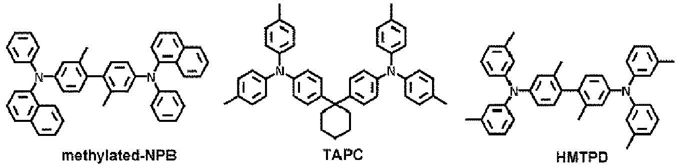

A thickness of the hole transport region may be in a range of about 50 Å to about 10,000 Å, for example, about 100 Å to about 4,000 Å. When the hole transport region includes a hole injection layer, a hole transport layer, or any combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer, and the hole transport layer are within these ranges, suitable or satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block or reduce leakage of electrons from an emission layer to a hole transport region. Materials that may be included in the hole transport region may be included in the emission auxiliary layer and the electron blocking layer.

### p-dopant

The hole transport region may further include, in addition to these materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

For example, a lowest unoccupied molecular orbital (LUMO) energy level of the p-dopant may be -3.5 eV or less.

In an embodiment, the p-dopant may include a quinone derivative, a cyano group-containing compound, a compound including element EL1 and element EL2, or any combination thereof.

Examples of the quinone derivative may include TCNQ, F4-TCNQ, and the like.

Examples of the cyano group-containing compound may include HAT-CN, PDM, a compound represented by Formula 221, and the like: 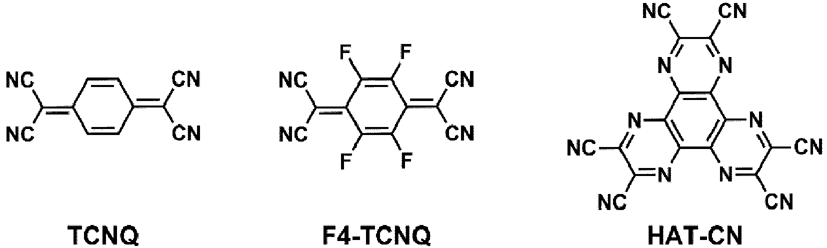 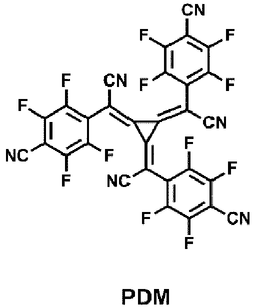 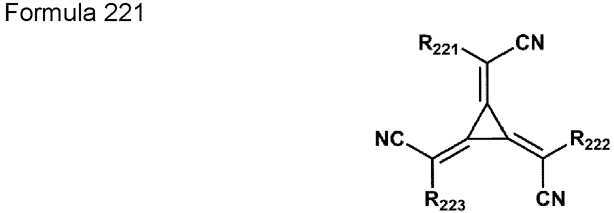 wherein, in Formula 221,
R₂₂₁ to R₂₂₃ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ, and
at least one of R₂₂₁ to R₂₂₃ may each independently be a C₃-C₆₀ (*e.g.* C₃-C₃₀) carbocyclic group or a C₁-C₆₀ (*e.g.* C₁-C₂₀) heterocyclic group, each substituted with a cyano group; -F; -Cl; -Br; -I; a C₁-C₂₀ alkyl group substituted with a cyano group, -F, - Cl, -Br, -I, or any combination thereof; or any combination thereof.

In the compound including element EL1 and element EL2, element EL1 may be metal, metalloid, or any combination thereof, and element EL2 may be non-metal, metalloid, or any combination thereof.

Examples of the metal may include: an alkali metal (for example, lithium (Li), sodium (Na), potassium (K), rubidium (Rb), cesium (Cs), etc.); an alkaline earth metal (for example, beryllium (Be), magnesium (Mg), calcium (Ca), strontium (Sr), barium (Ba), etc.); a transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron (Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), etc.); a post-transition metal (for example, zinc (Zn), indium (In), tin (Sn), etc.); a lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.); or any combination thereof.

Examples of the metalloid may include silicon (Si), antimony (Sb), tellurium (Te), or any combination thereof.

Examples of the non-metal may include oxygen (O), halogen (for example, F, Cl, Br, I, etc.), or any combination thereof.

Examples of the compound including element EL1 and element EL2 may include metal oxide, metal halide (for example, metal fluoride, metal chloride, metal bromide, metal iodide, etc.), metalloid halide (for example, metalloid fluoride, metalloid chloride, metalloid bromide, metalloid iodide, etc.), metal telluride, or any combination thereof.

Examples of the metal oxide may include tungsten oxide (for example, WO, W₂O₃, WO₂, WO₃, W₂O₅, etc.), vanadium oxide (for example, VO, V₂O₃, VO₂, V₂O₅, etc.), molybdenum oxide (MoO, Mo₂O₃, MoO₂, MoOs, Mo₂O₅, etc.), rhenium oxide (for example, ReOs, etc.), or any combination thereof.

Examples of the metal halide may include alkali metal halide, alkaline earth metal halide, transition metal halide, post-transition metal halide, lanthanide metal halide, or any combination thereof.

Examples of the alkali metal halide may include LiF, NaF, KF, RbF, CsF, LiCl, NaCl, KCl, RbCl, CsCl, LiBr, NaBr, KBr, RbBr, CsBr, Lil, Nal, KI, Rbl, Csl, or any combination thereof.

Examples of the alkaline earth metal halide may include BeF₂, MgF₂, CaF₂, SrF₂, BaF₂, BeCl₂, MgCl₂, CaCl₂, SrCl₂, BaCl₂, BeBr₂, MgBr₂, CaBr₂, SrBr₂, BaBr₂, BeI₂, MgI₂, CaI₂, SrI₂, BaI₂, or any combination thereof.

Examples of the transition metal halide may include titanium halide (for example, TiF₄, TiCl₄, TiBr₄, TiI₄, etc.), zirconium halide (for example, ZrF₄, ZrCl₄, ZrBr₄, ZrI₄, etc.), hafnium halide (for example, HfF₄, HfCl₄, HfBr₄, HfI₄, etc.), vanadium halide (for example, VF₃, VCl₃, VBr₃, VI₃, etc.), niobium halide (for example, NbFs, NbCl₃, NbBr₃, NbI₃, etc.), tantalum halide (for example, TaF₃, TaCl₃, TaBr₃, TaI₃, etc.), chromium halide (for example, CrFs, CrC1₃, CrBr₃, CrI₃, etc.), molybdenum halide (for example, MoF₃, MoCls, MoBrs, MoI₃, etc.), tungsten halide (for example, WF₃, WCl₃, WBrs, WIs, etc.), manganese halide (for example, MnF₂, MnCl₂, MnBr₂, MnI₂, etc.), technetium halide (for example, TcF₂, TcCl₂, TcBr₂, TcI₂, etc.), rhenium halide (for example, ReF₂, ReCl₂, ReBr₂, ReI₂, etc.), iron halide (for example, FeF₂, FeCl₂, FeBr₂, FeI₂, etc.), ruthenium halide (for example, RuF₂, RuCl₂, RuBr₂, RuI₂, etc.), osmium halide (for example, OsF₂, OsCl₂, OsBr₂, OsI₂, etc.), cobalt halide (for example, CoF₂, CoCl₂, CoBr₂, CoI₂, etc.), rhodium halide (for example, RhF₂, RhCl₂, RhBr₂, RhI₂, etc.), iridium halide (for example, IrF₂, IrCl₂, IrBr₂, IrI₂, etc.), nickel halide (for example, NiF₂, NiCl₂, NiBr₂, NiI₂, etc.), palladium halide (for example, PdF₂, PdCl₂, PdBr₂, PdI₂, etc.), platinum halide (for example, PtF₂, PtCl₂, PtBr₂, PtI₂, etc.), copper halide (for example, CuF, CuCl, CuBr, Cul, etc.), silver halide (for example, AgF, AgCl, AgBr, Agl, etc.), gold halide (for example, AuF, AuCl, AuBr, Aul, etc.), or any combination thereof.

Examples of the post-transition metal halide may include zinc halide (for example, ZnF₂, ZnCl₂, ZnBr₂, ZnI₂, etc.), indium halide (for example, InI₃, etc.), tin halide (for example, SnI₂, etc.), or any combination thereof.

Examples of the lanthanide metal halide may include YbF, YbF₂, YbF₃, SmF₃, YbCl, YbCl₂, YbCl₃, SmCl₃, YbBr, YbBr₂, YbBr₃, SmBr₃, YbI, YbI₂, YbI₃, SmI₃, or any combination thereof.

Examples of the metalloid halide may include antimony halide (for example, SbCI₅, etc.).

Examples of the metal telluride may include alkali metal telluride (for example, Li₂Te, Na₂Te, K₂Te, Rb₂Te, Cs₂Te, etc.), alkaline earth metal telluride (for example, BeTe, MgTe, CaTe, SrTe, BaTe, etc.), transition metal telluride (for example, TiTe₂, ZrTe₂, HfTe₂, V₂Te₃, Nb₂Te₃, Ta₂Te₃, Cr₂Te₃, Mo₂Te₃, W₂Te₃, MnTe, TcTe, ReTe, FeTe, RuTe, OsTe, CoTe, RhTe, IrTe, NiTe, PdTe, PtTe, Cu₂Te, CuTe, Ag₂Te, AgTe, Au₂Te, etc.), post-transition metal telluride (for example, ZnTe, etc.), lanthanide metal telluride (for example, LaTe, CeTe, PrTe, NdTe, PmTe, EuTe, GdTe, TbTe, DyTe, HoTe, ErTe, TmTe, YbTe, LuTe, etc.), or any combination thereof.

### Emission layer in interlayer 130

When the light-emitting device 10 is a full-color light-emitting device, the emission layer may be patterned into a red emission layer, a green emission layer, and/or a blue emission layer, according to a sub-pixel. In one or more embodiments, the emission layer may have a stacked structure of two or more layers of a red emission layer, a green emission layer, and a blue emission layer, in which the two or more layers contact (e.g., physically contact) each other or are separated from each other to emit white light. In one or more embodiments, the emission layer may have a structure in which two or more materials of a red light-emitting material, a green light-emitting material, and a blue light-emitting material are mixed together with each other in a single layer, and thus emit white light.

The emission layer may include a host and a dopant. The dopant may include a phosphorescent dopant, a fluorescent dopant, or any combination thereof.

The amount of the dopant in the emission layer may be from about 0.01 parts by weight to about 15 parts by weight based on 100 parts by weight of the host.

In one or more embodiments, the emission layer may include a quantum dot.

In some embodiments, the emission layer may include a delayed fluorescence material. The delayed fluorescence material may act as a host or a dopant in the emission layer.

A thickness of the emission layer may be in a range of about 100 Å to about 1,000 Å, for example, about 200 Å to about 600 Å. When the thickness of the emission layer is within these ranges, excellent light-emission characteristics may be obtained without a substantial increase in driving voltage.

### Host

The host may include a compound represented by Formula 301:

Formula 301 [Ar₃₀₁]_{xb11}-[(L₃₀₁)_{xb1}-R₃₀₁]_{xb21}

wherein, in Formula 301,
Ar₃₀₁ and L₃₀₁ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
xb11 may be 1, 2, or 3,
xb1 may be an integer selected from 0 to 5,
R₃₀₁ may be hydrogen, deuterium, -F, -Cl, -Br, -I, a hydroxyl group, a cyano group, a nitro group, a C₁-C₆₀ (*e.g.* C₁-C₂₀) alkyl group unsubstituted or substituted with at least one R₁₀ₐ, a C₂-C₆₀ (*e.g.* C₂-C₂₀) alkenyl group unsubstituted or substituted with at least one R₁₀ₐ, a C₂-C₆₀ (*e.g.* C₂-C₂₀) alkynyl group unsubstituted or substituted with at least one R₁₀ₐ, a C₁-C₆₀ (*e.g.* C₁-C₂₀) alkoxy group unsubstituted or substituted with at least one R₁₀ₐ, a C₃-C₆₀ (*e.g.* C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ,-Si(Q₃₀₁)(Q₃₀₂)(Q₃₀₃), -N(Q₃₀₁)(Q₃₀₂), -B(Q₃₀₁)(Q₃₀₂), - C(=O)(Q₃₀₁), -S(=O)₂(Q₃₀₁), or -P(=O)(Q₃₀₁)(Q₃₀₂),
xb21 may be an integer selected from 1 to 5, and
Q₃₀₁ to Q₃₀₃ are each the same as described in connection with Q₁.

For example, when xb11 in Formula 301 is 2 or more, two or more of Ar₃₀₁(s) may be linked to each other via a single bond.

In one or more embodiments, the host may include a compound represented by Formula 301-1, a compound represented by Formula 301-2, or any combination thereof: 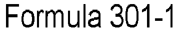 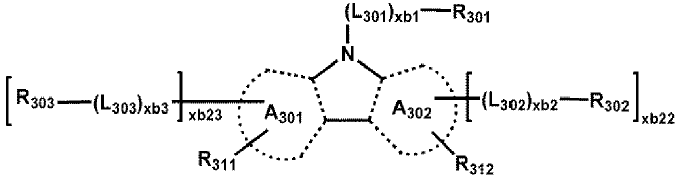 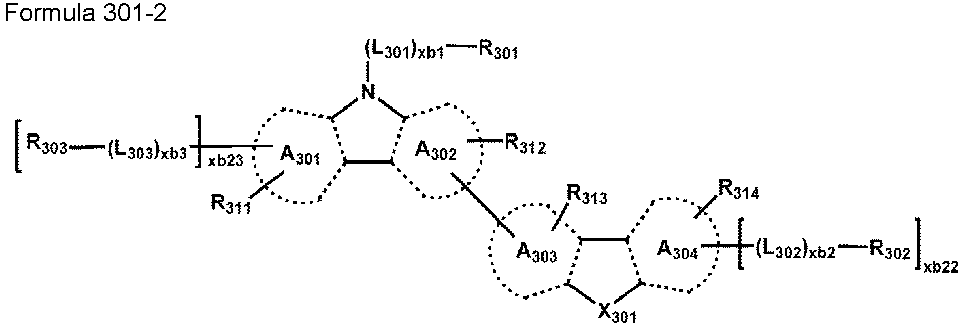 wherein, in Formulae 301-1 and 301-2,
ring A₃₀₁ to ring A₃₀₄ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
X₃₀₁ may be O, S, N[(L₃₀₄)_{xb4}-R₃₀₄], C(R₃₀₄)(R₃₀₅), or Si(R₃₀₄)(R₃₀₅),
xb22 and xb23 may each independently be 0, 1, or 2,
L₃₀₁, xb1, and R₃₀₁ are each the same as described herein in connection with Formula 301,
L₃₀₂ to L₃₀₄ are each independently the same as described in connection with L₃₀₁,
xb2 to xb4 are each independently the same as described in connection with xb1, and
R₃₀₂ to R₃₀₅ and R₃₁₁ to R₃₁₄ are each the same as described in connection with R₃₀₁.

In one or more embodiments, the host may include a compound represented by Formula 302:

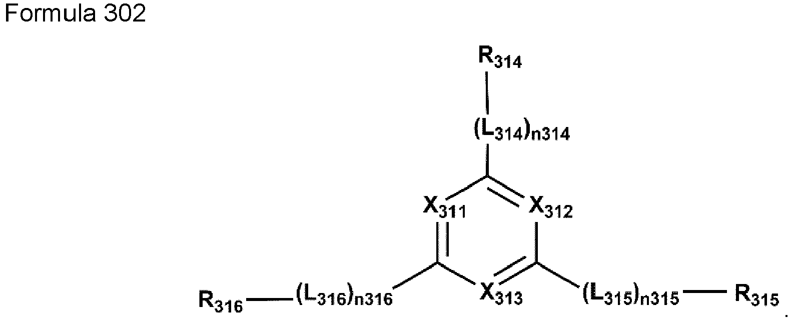

In Formula 302,
X₃₁₁ may be C(R₃₁₁) or N,
X₃₁₂ may be C(R₃₁₂) or N,
X₃₁₃ may be C(R₃₁₃) or N,
at least one selected from X₃₁₁ to X₃₁₃ may be N,
L₃₁₄ to L₃₁₅ are each independently a single bond, a C₃-C₆₀ (*e.g.* C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, - C(Q₃₁₁)(Q₃₁₂)-, -Si(Q₃₁₁)(Q₃₁₂)-, -B(Q₃₁₁)- or -N(Q₃₁₁)-,
n314 to n316 may be each independently an integer selected from 1 to 5,
R₃₁₁ to R₃₁₆ are each the same as described in connection with R₃₀₁. Q₃₁₁ and Q₃₁₂ are each the same as described in connection with Q₁.

In one or more embodiments, the host may include an alkali earth metal complex, a post-transition metal complex, or any combination thereof. For example, the host may include a Be complex (for example, Compound H55), an Mg complex, a Zn complex, or any combination thereof.

In one or more embodiments, the host may include one of Compounds H1 to H126, 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di(9-carbazolyl)benzene (mCP), 1,3,5-tri(carbazol-9-yl)benzene (TCP), or any combination thereof:

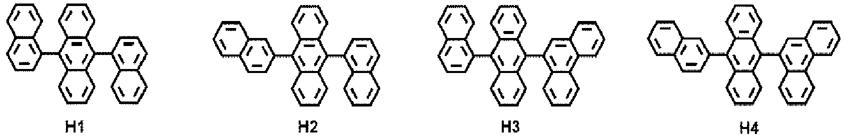

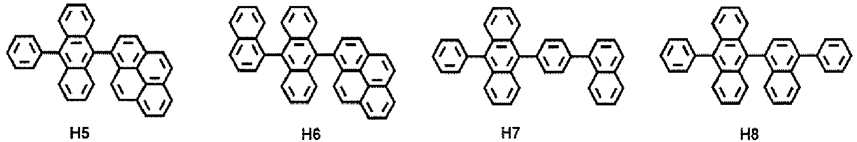

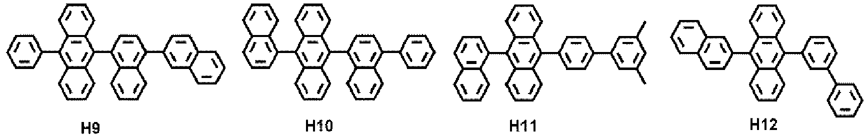

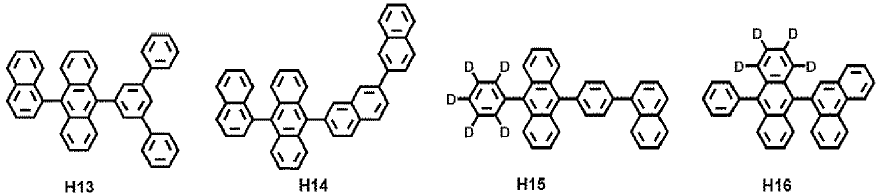

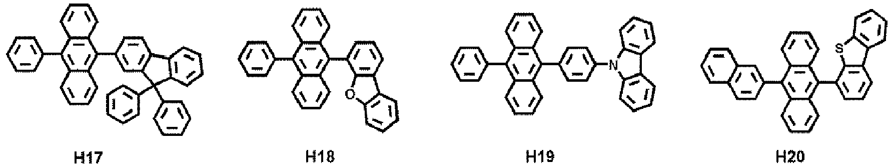

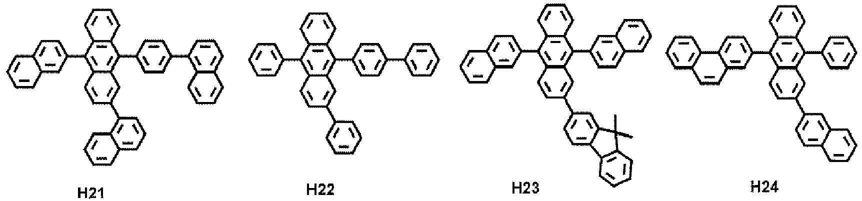

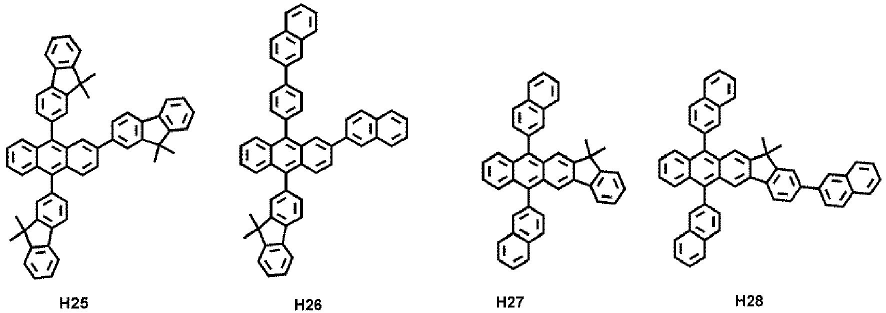

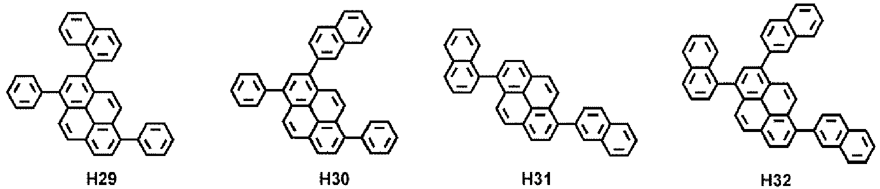

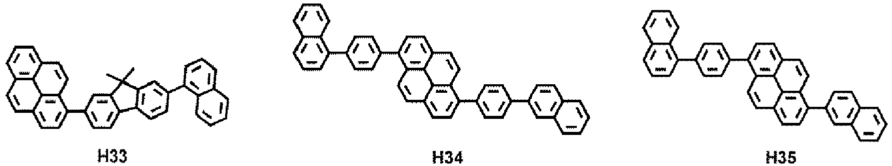

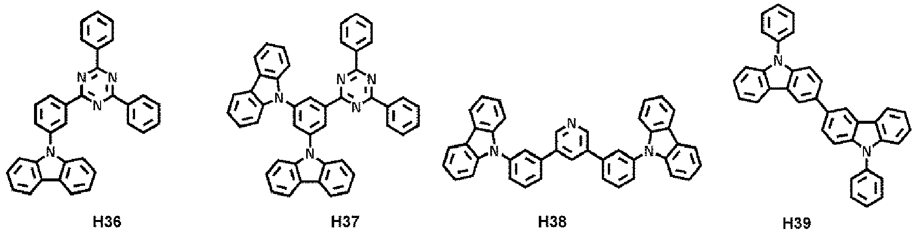

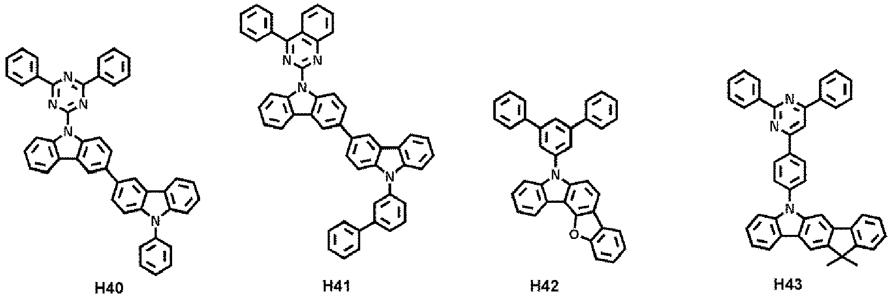

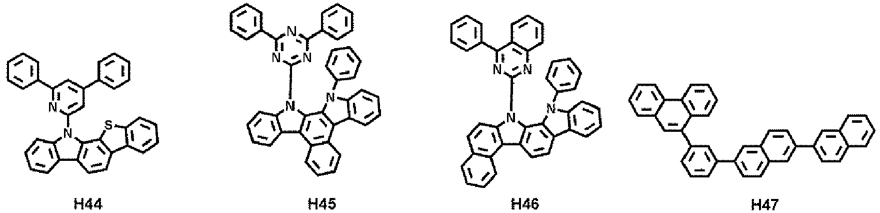

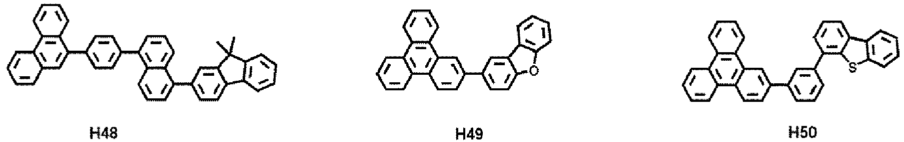

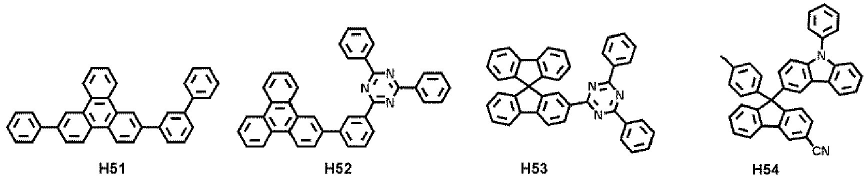

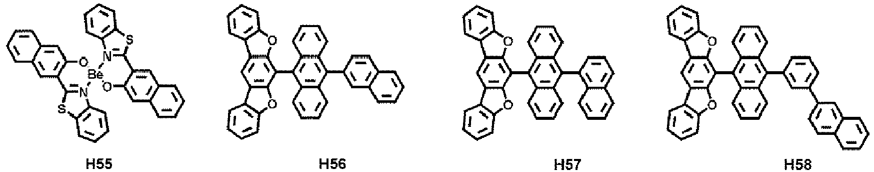

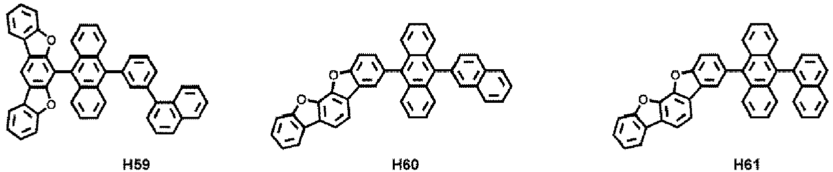

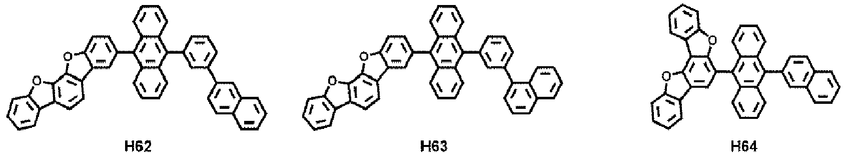

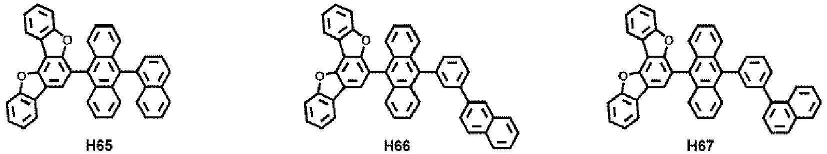

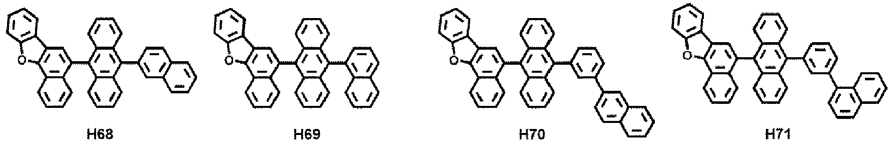

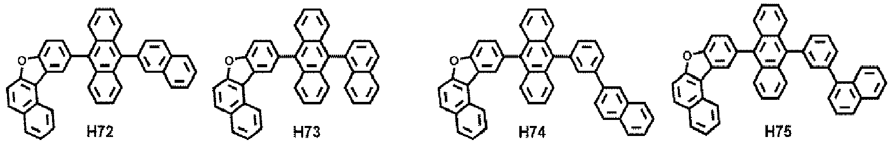

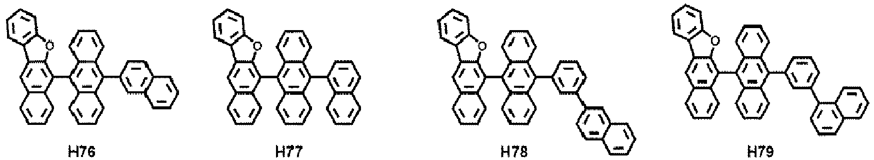

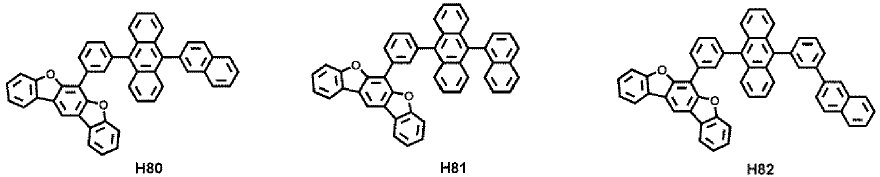

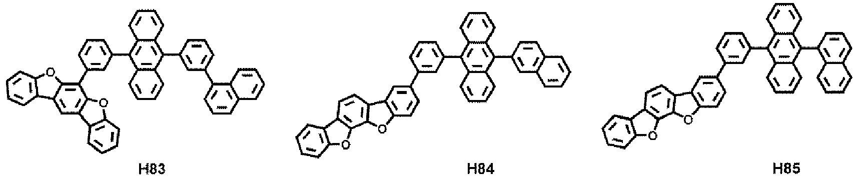

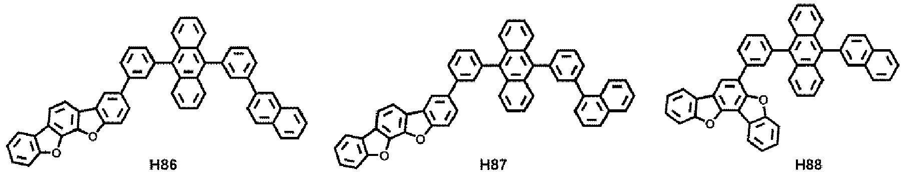

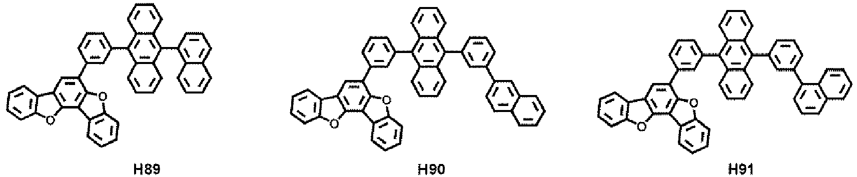

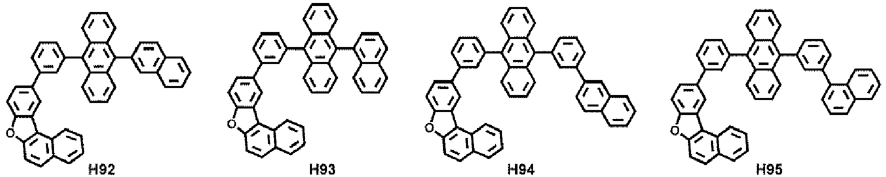

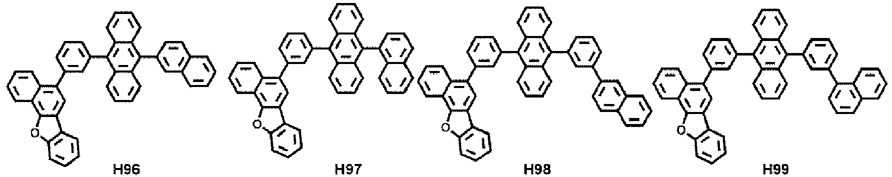

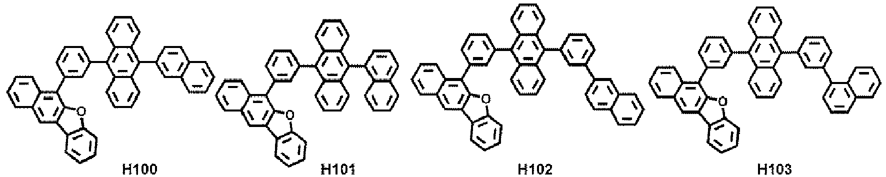

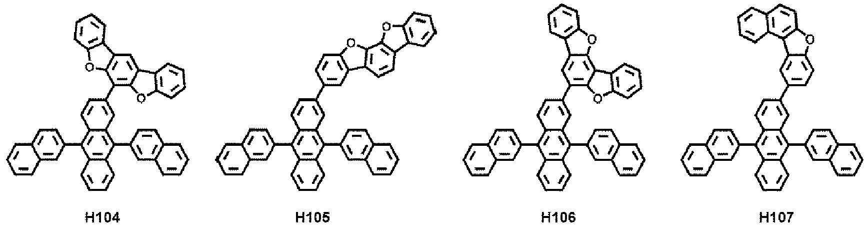

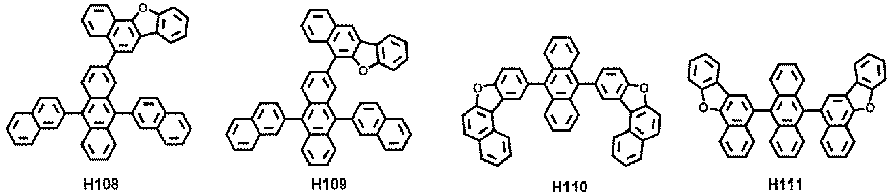

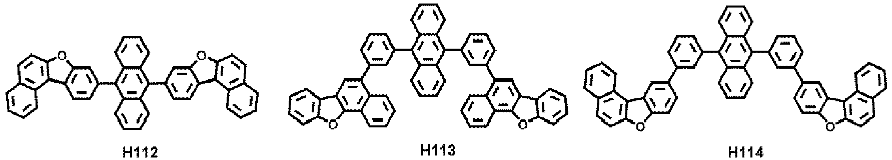

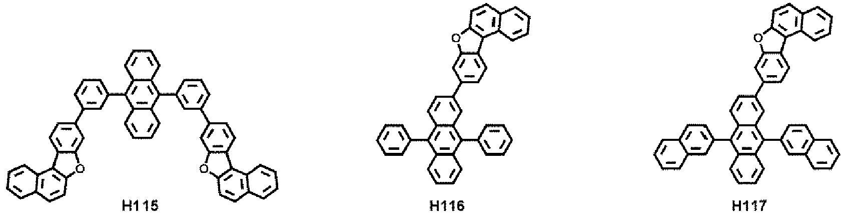

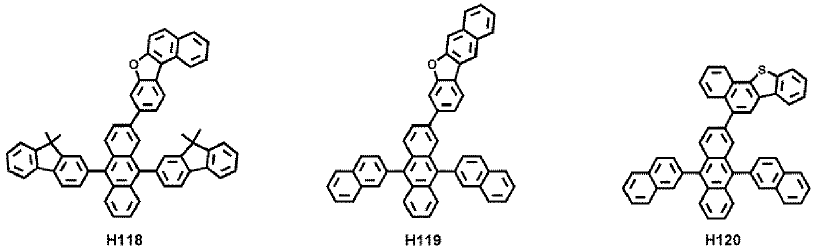

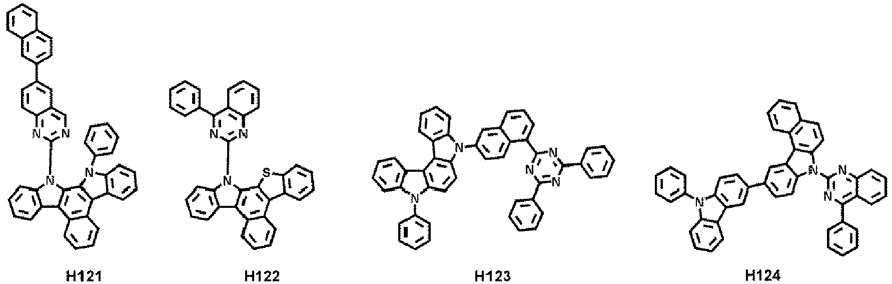

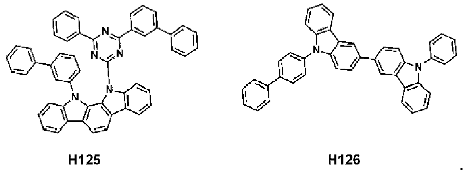

### Phosphorescent dopant

The phosphorescent dopant may include at least one transition metal as a center metal.

The phosphorescent dopant may include a monodentate ligand, a bidentate ligand, a tridentate ligand, a tetradentate ligand, a pentadentate ligand, a hexadentate ligand, or any combination thereof.

The phosphorescent dopant may be electrically neutral.

For example, the phosphorescent dopant may include an organometallic compound represented by Formula 401:

Formula 401 M(L₄₀₁)_{xc1}(L₄₀₂)_{xc2}

wherein, in Formula 401,
M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),
L₄₀₁ may be a ligand represented by Formula 402, and xc1 may be 1, 2, or 3, wherein, when xc1 is 2 or more, two or more of L₄₀₁(s) may be identical to or different from each other,
L₄₀₂ may be an organic ligand, and xc2 may be 0, 1, 2, 3, or 4, wherein, when xc2 is 2 or more, two or more of L₄₀₂(s) may be identical to or different from each other,

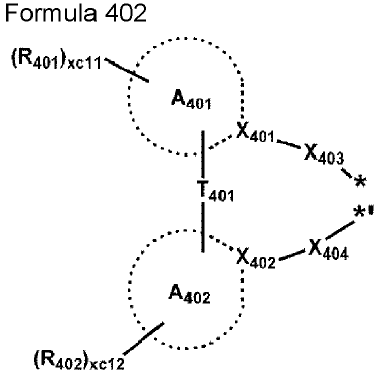

In Formula 402, X₄₀₁ and X₄₀₂ may each independently be nitrogen or carbon,
ring A₄₀₁ and ring A₄₀₂ may each independently be a C₃-C₆₀ (*e.g.* C₃-C₃₀) carbocyclic group or a C₁-C₆₀ (*e.g.* C₁-C₂₀) heterocyclic group,
T₄₀₁ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*',
X₄₀₃ and X₄₀₄ may each independently be a chemical bond (for example, a covalent bond or a coordination bond), O, S, N(Q₄₁₃), B(Q₄₁₃), P(Q₄₁₃), C(Q₄₁₃)(Q₄₁₄), or Si(Q413)(Q414),
Q₄₁₁ to Q₄₁₄ are each the same as described in connection with Q₁,
R₄₀₁ and R₄₀₂ may each independently be hydrogen, deuterium, -F, -Cl, -Br, - I, a hydroxyl group, a cyano group, a nitro group, a C₁-C₂₀ alkyl group unsubstituted or substituted with at least one R₁₀ₐ, a C₁-C₂₀ alkoxy group unsubstituted or substituted with at least one R₁₀ₐ, a C₃-C₆₀ (*e.g.* C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), or -P(=O)(Q₄₀₁)(Q₄₀₂),
Q₄₀₁ to Q₄₀₃ are each the same as described in connection with Q₁,
xc11 and xc12 may each independently be an integer selected from 0 to 10, and
* and *' in Formula 402 each indicate a binding site to M in Formula 401.

For example, in Formula 402, i) X₄₀₁ may be nitrogen, and X₄₀₂ may be carbon, or ii) X₄₀₁ and X₄₀₂ may each be nitrogen.

In one or more embodiments, when xc1 in Formula 401 is 2 or more, two ring A₄₀₁(s) in two or more of L₄₀₁(s) may be optionally linked to each other via T₄₀₂, which is a linking group, or two ring A₄₀₂(s) may be optionally linked to each other via T₄₀₃, which is a linking group (see Compounds PD1 to PD4 and PD7). T₄₀₂ and T₄₀₃ are each the same as described in connection with T₄₀₁.

L₄₀₂ in Formula 401 may be an organic ligand. For example, L₄₀₂ may include a halogen group, a diketone group (for example, an acetylacetonate group), a carboxylic acid group (for example, a picolinate group), -C(=O) group, an isonitrile group, -CN group, a phosphorus containing group (for example, a phosphine group, a phosphite group, etc.), or any combination thereof.

The phosphorescent dopant may include, for example, one of compounds PD1 to PD48, or any combination thereof:

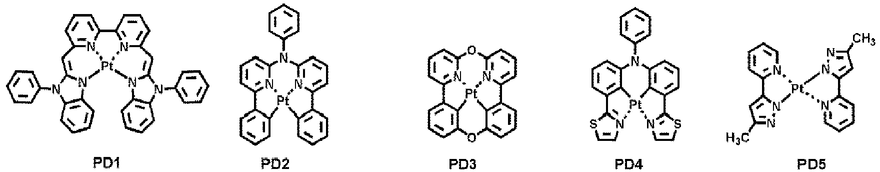

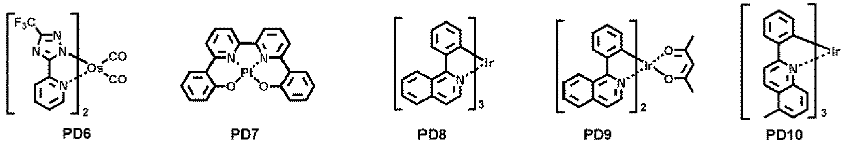

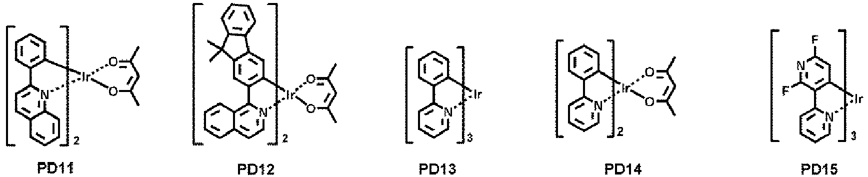

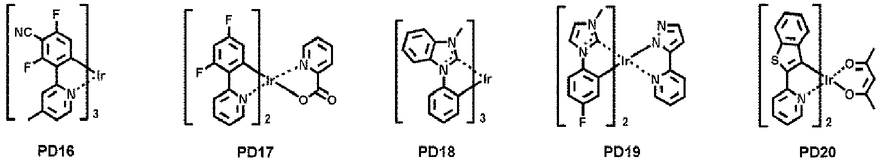

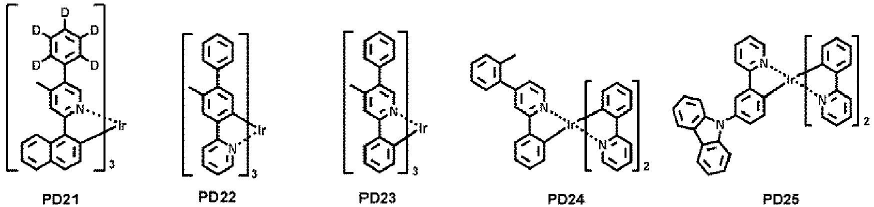

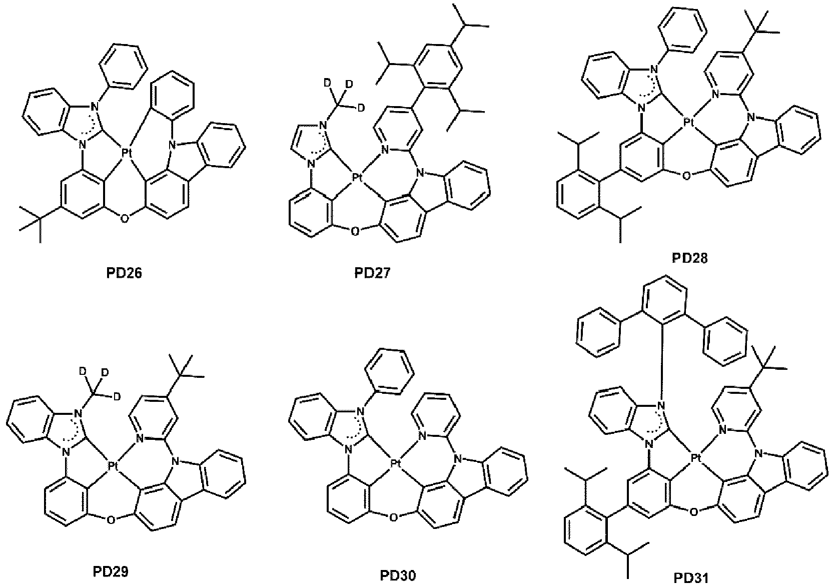

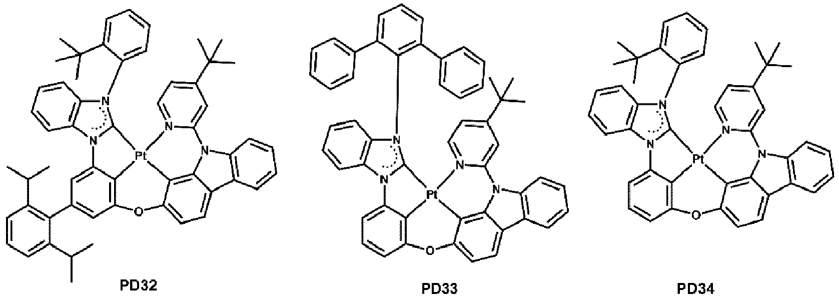

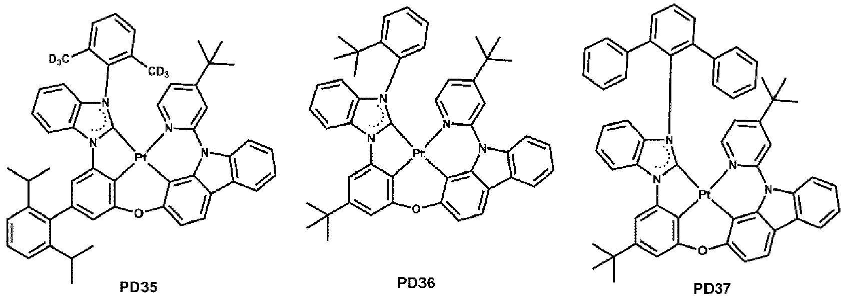

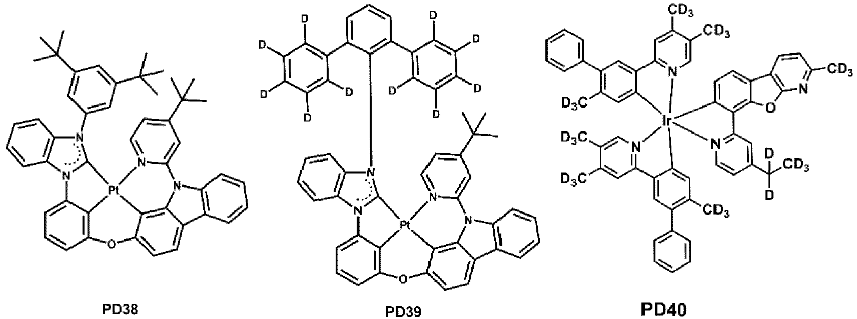

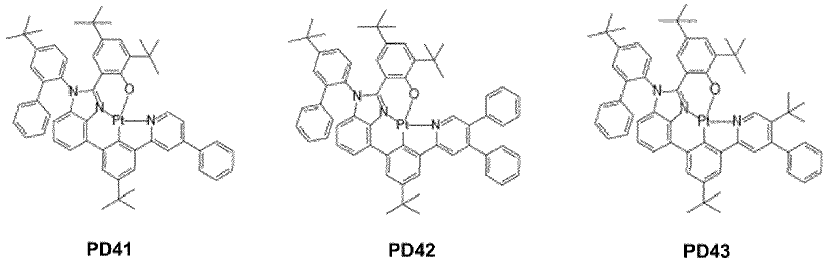

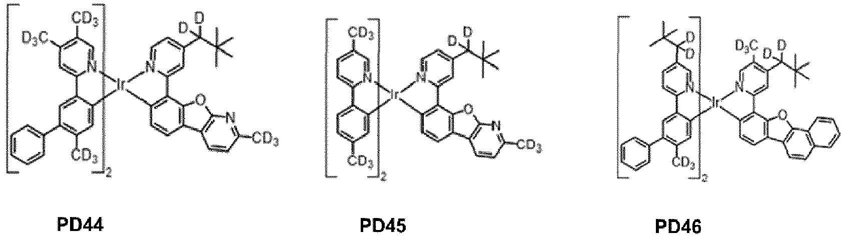

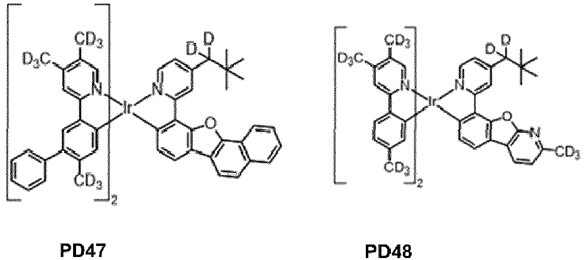

### Fluorescent dopant

The fluorescent dopant may include an amine group-containing compound, a styryl group-containing compound, or any combination thereof.

For example, the fluorescent dopant may include a compound represented by Formula 501: 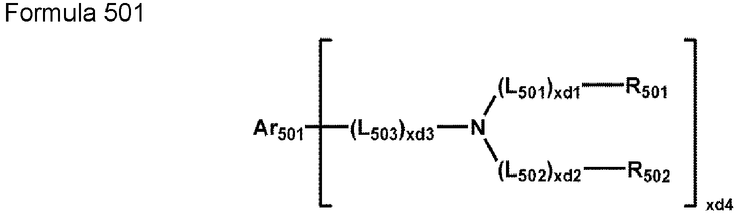 wherein, in Formula 501,
Ar₅₀₁, L₅₀₁ to L₅₀₃, R₅₀₁, and R₅₀₂ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
xd1 to xd3 may each independently be 0, 1, 2, or 3, and
xd4 may be 1, 2, 3, 4, 5, or 6.

For example, Ar₅₀₁ in Formula 501 may be a condensed cyclic group (for example, an anthracene group, a chrysene group, a pyrene group, etc.) in which three or more monocyclic groups are condensed together.

In one or more embodiments, xd4 in Formula 501 may be 2.

For example, the fluorescent dopant may include: one of Compounds FD1 to FD36; DPVBi; DPAVBi; or any combination thereof:

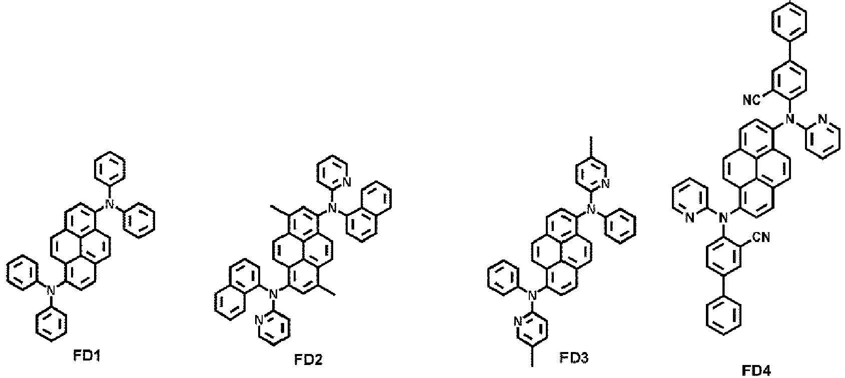

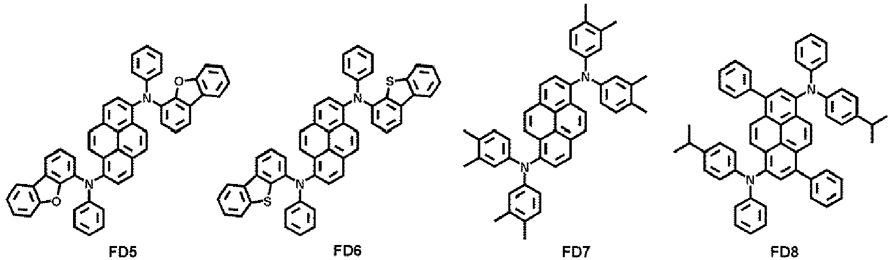

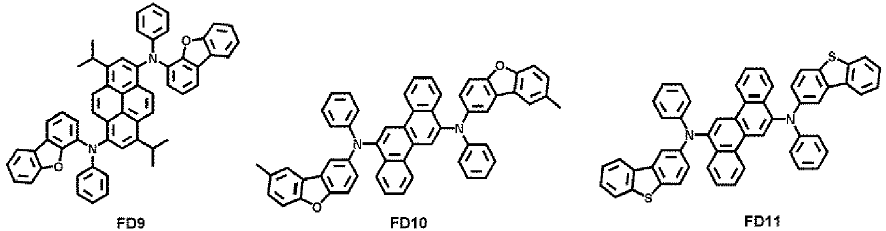

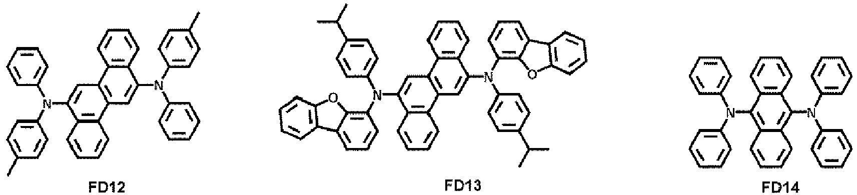

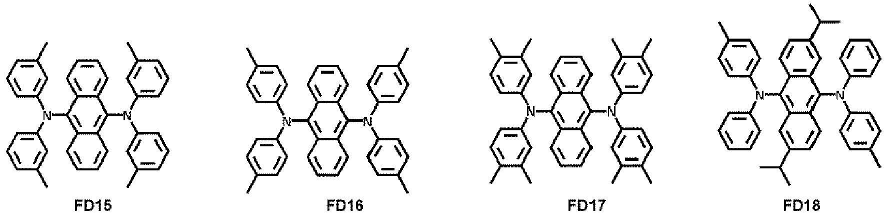

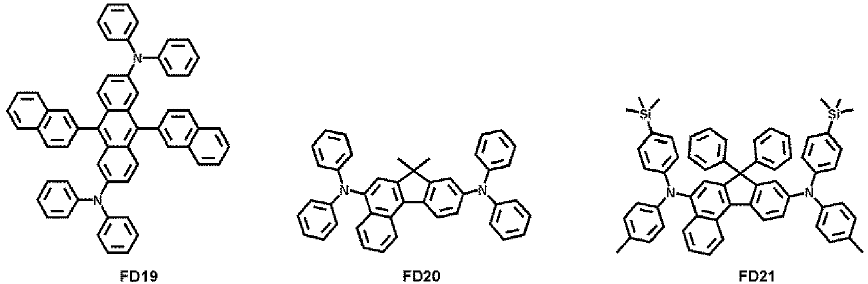

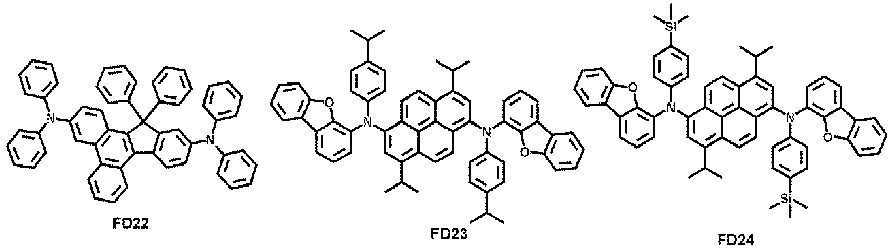

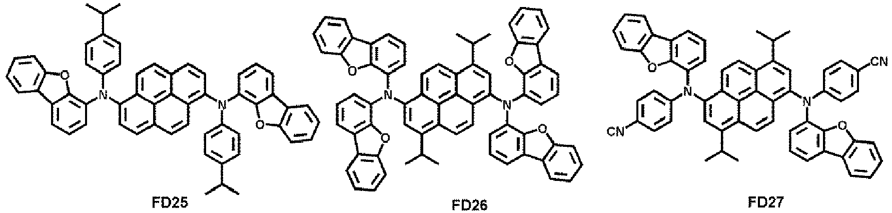

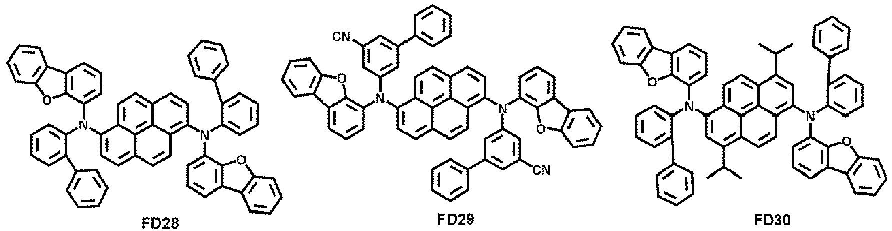

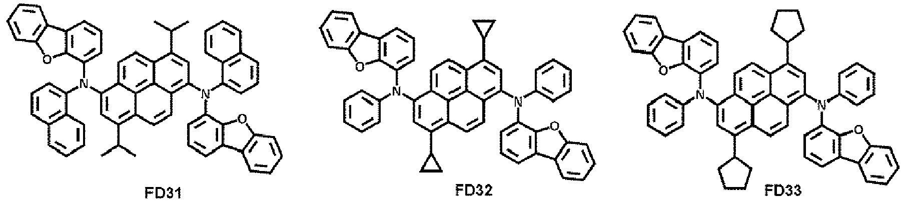

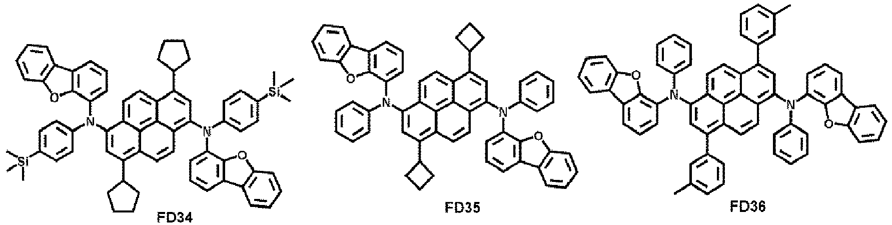

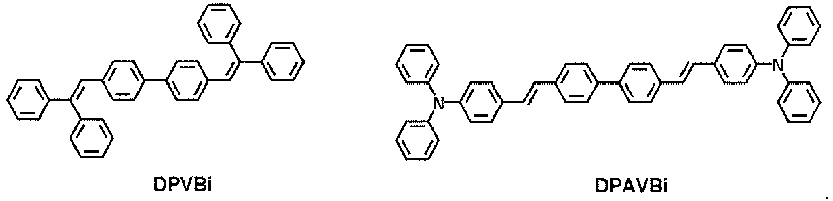

### Delayed fluorescence material

The emission layer may include a delayed fluorescence material.

In the present specification, the delayed fluorescence material may be selected from compounds capable of emitting delayed fluorescent light based on a delayed fluorescence emission mechanism.

The delayed fluorescence material included in the emission layer may act as a host or a dopant, depending on the type (or kind) of other materials included in the emission layer.

In an embodiment, a difference between the triplet energy level of the delayed fluorescence material and the singlet energy level of the delayed fluorescence material may be greater than or equal to 0 eV and less than or equal to 0.5 eV. When the difference between the triplet energy level of the delayed fluorescence material and the singlet energy level of the delayed fluorescence material satisfies the above-described range, up-conversion from the triplet state to the singlet state of the delayed fluorescence materials may effectively occur, and thus, the luminescence efficiency of the light-emitting device 10 may be improved.

For example, the delayed fluorescence material may include i) a material including at least one electron donor (for example, a π electron-rich C₃-C₆₀ (*e.g.* C₃-C₃₀) cyclic group, such as a carbazole group) and at least one electron acceptor (for example, a sulfoxide group, a cyano group, or a π electron-deficient nitrogen-containing C₁-C₆₀ (*e.g.* C₁-C₃₀) cyclic group), and ii) a material including a C₈-C₆₀ (*e.g.* C₈-C₃₀) polycyclic group in which two or more cyclic groups are condensed together while sharing a boron atom (B).

Examples of the delayed fluorescence material may include at least one selected from Compounds DF1 to DF9:

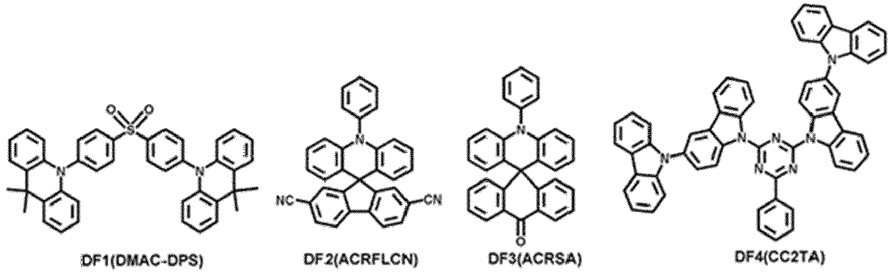

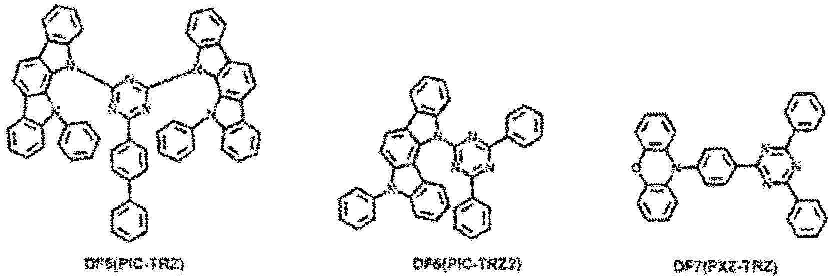

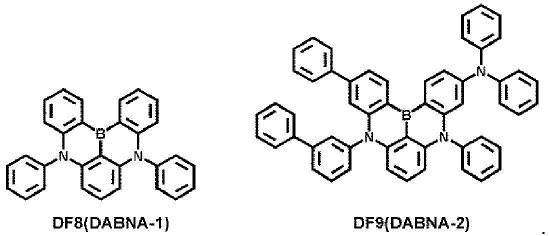

### Quantum dot

The emission layer may include a quantum dot.

The term "quantum dot," as used herein, refers to a crystal of a semiconductor compound, and may include any suitable material capable of emitting light of various suitable emission wavelengths according to the size of the crystal.

A diameter of the quantum dot may be, for example, in a range of about 1 nm to about 10 nm.

The quantum dot may be synthesized by a wet chemical process, a metal organic chemical vapor deposition (MOCVD) process, a molecular beam epitaxy (MBE) process, and/or any suitable process similar thereto.

The wet chemical process is a method including mixing together a precursor material with an organic solvent and then growing a quantum dot particle crystal. When the quantum dot particle crystal grows, the organic solvent naturally acts as a dispersant coordinated on the surface of the quantum dot partical crystal and controls the growth of the crystal so that the growth of quantum dot particle crystal can be controlled through a process which costs less, and is easier than vapor deposition methods, such as metal organic chemical vapor deposition process or molecular beam epitaxy process.

The quantum dot may include: a Group II-VI semiconductor compound; a Group III-V semiconductor compound; a Group III-VI semiconductor compound; a Group I-III-VI semiconductor compound; a Group IV-VI semiconductor compound; a Group IV element or compound; or any combination thereof.

Examples of the Group II-VI semiconductor compound may include: a binary compound, such as CdSe, CdTe, ZnS, ZnSe, ZnTe, ZnO, HgS, HgSe, HgTe, MgSe, and/or MgS; a ternary compound, such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, and/or MgZnS; a quaternary compound, such as CdZnSeS, CdZnSeTe, CdZnSTe, CdHgSeS, CdHgSeTe, CdHgSTe, HgZnSeS, HgZnSeTe, and/or HgZnSTe; or any combination thereof.

Examples of the Group III-V semiconductor compound may include: a binary compound, such as GaN, GaP, GaAs, GaSb, AlN, AlP, AlAs, AlSb, InN, InP, InAs, and/or InSb; a ternary compound, such as GaNP, GaNAs, GaNSb, GaPAs, GaPSb, AlNP, AlNAs, AlNSb, AlPAs, AlPSb, InGaP, InNP, InAlP, InNAs, InNSb, InPAs, and/or InPSb; a quaternary compound, such as GaAlNP, GaAlNAs, GaAlNSb, GaAlPAs, GaAlPSb, GalnNP, GalnNAs, GalnNSb, GalnPAs, GalnPSb, InAlNP, InAlNAs, InAlNSb, InAlPAs, and/or InAlPSb; or any combination thereof. In some embodiments, the Group III-V semiconductor compound may further include a Group II element. Examples of the Group III-V semiconductor compound further including the Group II element may include InZnP, InGaZnP, InAlZnP, and the like.

Examples of the Group III-VI semiconductor compound may include: a binary compound, such as GaS, GaSe, Ga₂Se₃, GaTe, InS, InSe, In₂S₃, In₂Se₃, and/or InTe; a ternary compound, such as InGaS₃, and/or InGaSe₃; or any combination thereof.

Examples of the Group I-III-VI semiconductor compound may include: a ternary compound, such as AgInS, AgInS₂, CuInS, CuInS₂, CuGaO₂, AgGaO₂, and/or AgAlO₂; or any combination thereof.

Examples of the Group IV-VI semiconductor compound may include: a binary compound, such as SnS, SnSe, SnTe, PbS, PbSe, and/or PbTe; a ternary compound, such as SnSeS, SnSeTe, SnSTe, PbSeS, PbSeTe, PbSTe, SnPbS, SnPbSe, and/or SnPbTe; a quaternary compound, such as SnPbSSe, SnPbSeTe, and/or SnPbSTe; or any combination thereof.

The Group IV element or compound may include: a single element material, such as Si and/or Ge; a binary compound, such as SiC and/or SiGe; or any combination thereof.

Each element included in a multi-element compound such as the binary compound, the ternary compound, and the quaternary compound may be present at a uniform concentration or non-uniform concentration in a particle.

In some embodiments, the quantum dot may have a single structure in which the concentration of each element in the quantum dot is uniform (e.g., substantially uniform), or a core/shell dual structure. For example, the material included in the core and the material included in the shell may be different from each other.

The shell of the quantum dot may act as a protective layer that prevents or reduces chemical degeneration of the core to maintain semiconductor characteristics, and/or as a charging layer that imparts electrophoretic characteristics to the quantum dot. The shell may be a single layer or a multi-layer. The interface between the core and the shell may have a concentration gradient in which the concentration of an element existing in the shell decreases along a direction toward the center of the core.

Examples of the shell of the quantum dot may include an oxide of metal, metalloid, or non-metal, a semiconductor compound, or any combination thereof. Examples of the oxide of metal, metalloid, or non-metal may include: a binary compound, such as SiO₂, Al₂O₃, TiO₂, ZnO, MnO, Mn₂O₃, Mn₃O₄, CuO, FeO, Fe₂O₃, Fe₃O₄, CoO, Co₃O₄, and/or NiO; a ternary compound, such as MgAl₂O₄, CoFe₂O₄, NiFe₂O₄, and/or CoMn₂O₄; or any combination thereof. Examples of the semiconductor compound may include, as described herein, a Group II-VI semiconductor compound; a Group III-V semiconductor compound; a Group III-VI semiconductor compound; a Group I-III-VI semiconductor compound; a Group IV-VI semiconductor compound; or any combination thereof. For example, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, AlSb, or any combination thereof.

A full width at half maximum (FWHM) of the emission wavelength spectrum of the quantum dot may be about 45 nm or less, for example, about 40 nm or less, for example, about 30 nm or less, and within these ranges, color purity and/or color reproducibility may be increased. In addition, because the light emitted through the quantum dot is emitted in all directions (e.g., substantially all directions), the wide viewing angle may be improved.

In addition, the quantum dot may be in the form of a spherical nanoparticle, a pyramidal nanoparticle, a multi-arm nanoparticle, a cubic nanoparticle, a nanotube, a nanowire, a nanofiber, and/or a nanoplate.

Because the energy band gap may be adjusted by controlling the size of the quantum dot, light having various suitable wavelength bands may be obtained from the quantum dot emission layer. Accordingly, by using quantum dots of different sizes, a light-emitting device that emits light of various suitable wavelengths may be implemented. In more detail, the size of the quantum dot may be selected to emit red, green and/or blue light. In addition, the size of the quantum dot may be configured to emit white light by combination of light of various suitable colors.

### Electron transport region in interlayer 130

The electron transport region may have i) a single-layered structure consisting of a single layer consisting of a single material, ii) a single-layered structure consisting of a single layer consisting of a plurality of different materials, or iii) a multi-layered structure including a plurality of layers including a plurality of different materials.

The electron transport region may include a buffer layer, a hole blocking layer, an electron control layer, an electron transport layer, an electron injection layer, or any combination thereof.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein, for each structure, constituting layers are sequentially stacked from the emission layer.

The electron transport region (for example, the buffer layer, the hole blocking layer, the electron control layer, and/or the electron transport layer in the electron transport region) may include a metal-free compound including at least one π electron-deficient nitrogen-containing C₁-C₆₀ (e.g. C₁-C₃₀) cyclic group.

For example, the electron transport region may include a compound represented by Formula 601:

Formula 601 [Ar₆₀₁]ₓₑ₁₁-[(L₆₀₁)ₓₑ₁-R₆₀₁]ₓₑ₂₁

wherein, in Formula 601,
Ar₆₀₁ and L₆₀₁ may each independently be a C₃-C₆₀ (*e.g.* C₃-C₃₀) carbocyclic group unsubstituted or substituted with at least one R₁₀ₐ or a C₁-C₆₀ (*e.g.* C₁-C₂₀) heterocyclic group unsubstituted or substituted with at least one R₁₀ₐ,
xe11 may be 1, 2, or 3,
xe1 may be 0, 1, 2, 3, 4, or 5,
R₆₀₁ may be a C₃-C₆₀ (*e.g.* C₃-C₃₀) carbocyclic group unsubstituted or substituted with at least one R₁₀ₐ, a C₁-C₆₀ (*e.g.* C₁-C₂₀) heterocyclic group unsubstituted or substituted with at least one R₁₀ₐ, -Si(Q₆₀₁)(Q₆₀₂)(Q₆₀₃), -C(=O)(Q₆₀₁), - S(=O)₂(Q₆₀₁), or -P(=O)(Q₆₀₁)(Q₆₀₂),
Q₆₀₁ to Q₆₀₃ are each the same as described in connection with Q₁,
xe21 may be 1, 2, 3, 4, or 5, and
at least one selected from Ar₆₀₁, L₆₀₁, and R₆₀₁ may each independently be a π electron-deficient nitrogen-containing C₁-C₆₀ (*e.g.* C₁-C₃₀) cyclic group unsubstituted or substituted with at least one R₁₀ₐ.

For example, in Formula 601, when xe11 is 2 or greater, at least two Ar₆₀₁(s) may be linked to each other via a single bond.

In one or more embodiments, Ar₆₀₁ in Formula 601 may be a substituted or unsubstituted anthracene group.

In one or more embodiments, the electron transport region may include a compound represented by Formula 601-1: 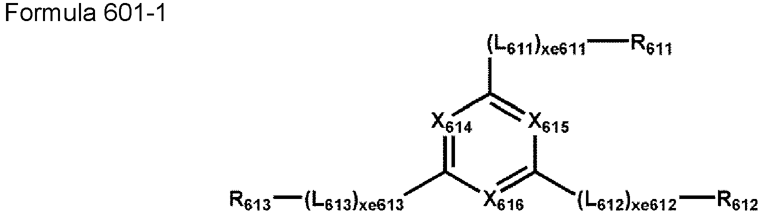 wherein, in Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
L₆₁₁ to L₆₁₃ are each the same as described in connection with L₆₀₁,
xe611 to xe613 are each the same as described in connection with xe1,
R₆₁₁ to R₆₁₃ are each the same as described in connection with R₆₀₁, and
R₆₁₄ to R₆₁₆ may each independently be hydrogen, deuterium, -F, -Cl, -Br, -I, a hydroxyl group, a cyano group, a nitro group, a C₁-C₂₀ (*e.g.* C₁-C₁₀) alkyl group, a C₁-C₂₀ (*e.g.* C₁-C₁₀) alkoxy group, a C₃-C₆₀ (*e.g.* C₃-C₃₀) carbocyclic group unsubstituted or substituted with at least one R₁₀ₐ, or a C₁-C₆₀ (*e.g.* C₁-C₂₀) heterocyclic group unsubstituted or substituted with at least one R₁₀ₐ.

For example, xe1 and xe611 to xe613 in Formulae 601 and 601-1 may each independently be 0, 1, or 2.

The electron transport region may include one of Compounds ET1 to ET46, 2,9-dimethyl-4,7-diphenyl-1,10-phenanthroline (BCP), 4,7-diphenyl-1,10-phenanthroline (Bphen), Alq₃, BAlq, TAZ, NTAZ, or any combination thereof:

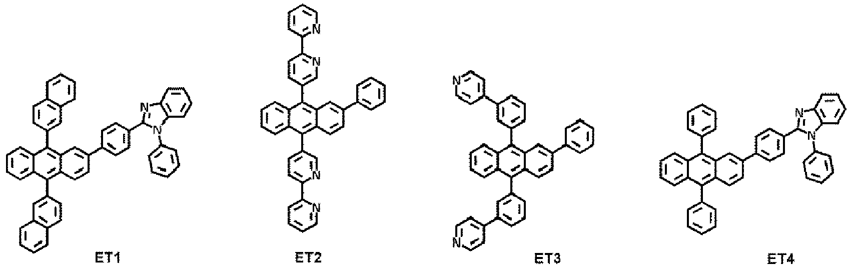

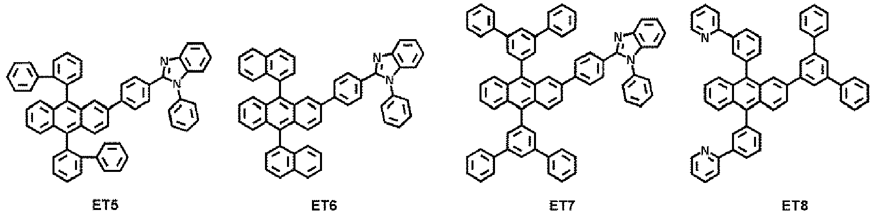

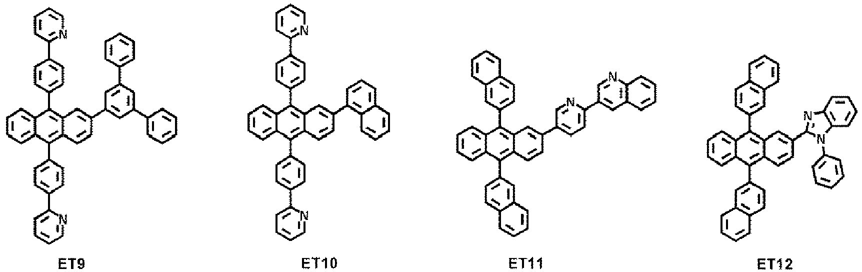

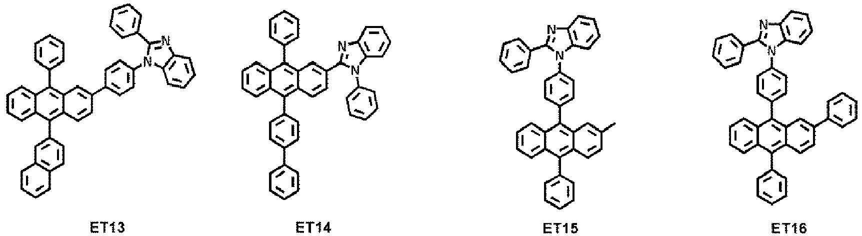

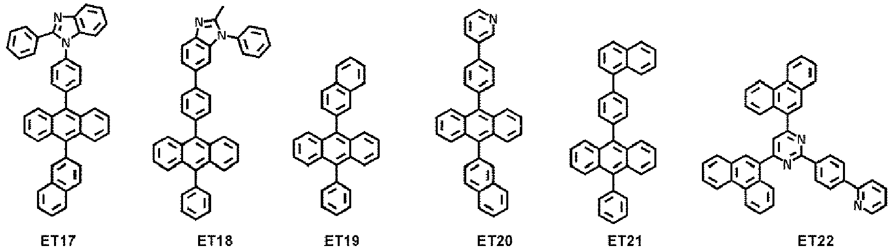

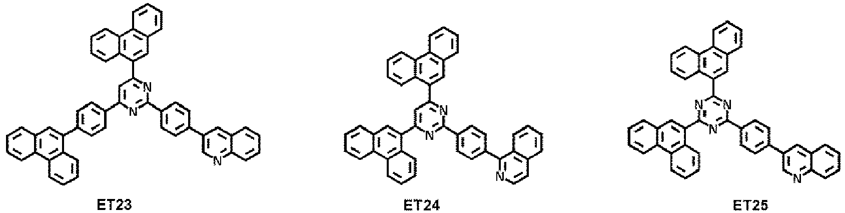

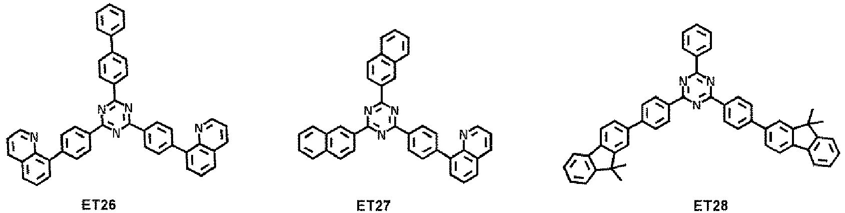

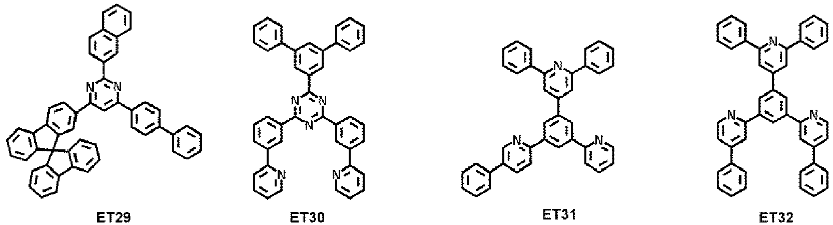

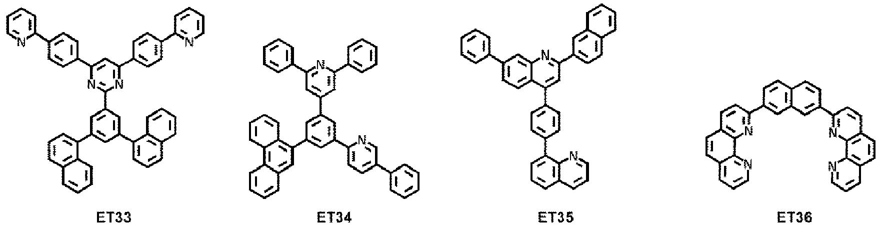

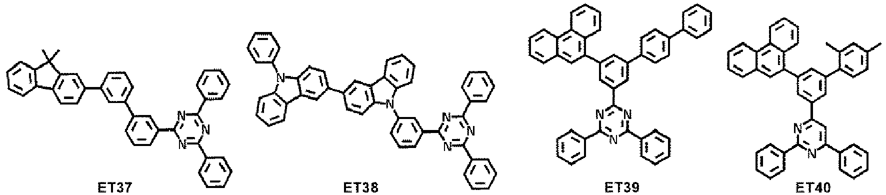

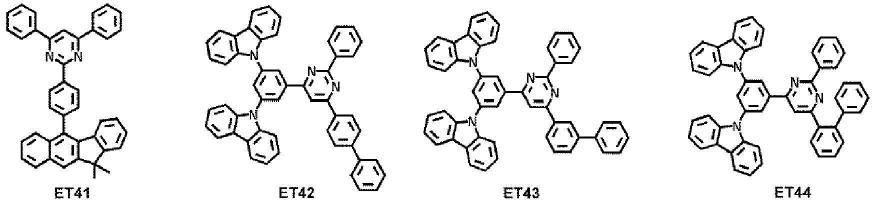

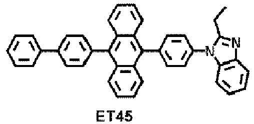

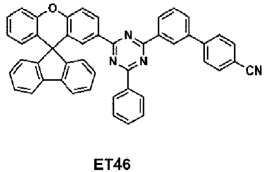

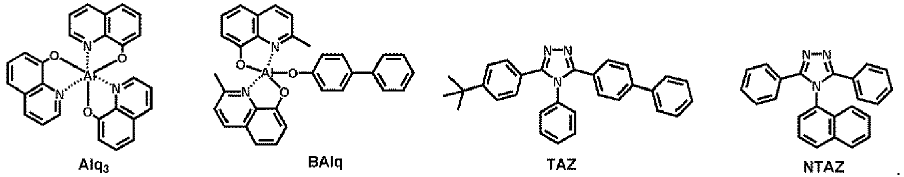

A thickness of the electron transport region may be from about 100 Å to about 5,000 Å, for example, about 160 Å to about 4,000 Å. When the electron transport region includes a buffer layer, a hole blocking layer, an electron control layer, an electron transport layer, or any combination thereof, a thickness of the buffer layer, the hole blocking layer, or the electron control layer may each independently be from about 20 Å to about 1,000 Å, for example, about 30 Å to about 300 Å, and a thickness of the electron transport layer may be from about 100 Å to about 1,000 Å, for example, about 150 Å to about 500 Å. When the thickness of the buffer layer, the hole blocking layer, the electron control layer, the electron transport layer, and/or the electron transport region are within these ranges, suitable or satisfactory electron transporting characteristics may be obtained without a substantial increase in driving voltage.

The electron transport region (for example, the electron transport layer in the electron transport region) may further include, in addition to the materials described above, a metal-containing material.

The metal-containing material may include an alkali metal complex, an alkaline earth metal complex, or any combination thereof. The metal ion of an alkali metal complex may be a Li ion, a Na ion, a K ion, a Rb ion, and/or a Cs ion, and the metal ion of an alkaline earth metal complex may be a Be ion, a Mg ion, a Ca ion, a Sr ion, and/or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or any combination thereof.

For example, the metal-containing material may include a Li complex. The Li complex may include, for example, Compound ET-D1 (Liq) or ET-D2:

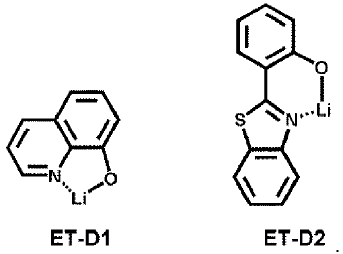

The electron transport region may include an electron injection layer that facilitates the injection of electrons from the second electrode 150. The electron injection layer may be in direct contact (e.g., physical contact) with the second electrode 150.

The electron injection layer may have i) a single-layered structure consisting of a single layer consisting of a single material, ii) a single-layered structure consisting of a single layer consisting of a plurality of different materials, or iii) a multi-layered structure including a plurality of layers including a plurality of different materials.

The electron injection layer may include an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof.

The alkali metal may include Li, Na, K, Rb, Cs, or any combination thereof. The alkaline earth metal may include Mg, Ca, Sr, Ba, or any combination thereof. The rare earth metal may include Sc, Y, Ce, Tb, Yb, Gd, or any combination thereof.

The alkali metal-containing compound, the alkaline earth metal-containing compound, and the rare earth metal-containing compound may be oxides, halides (for example, fluorides, chlorides, bromides, iodides, and/or the like), and/or tellurides of the alkali metal, the alkaline earth metal, and/or the rare earth metal, or any combination thereof.

The alkali metal-containing compound may include: alkali metal oxides, such as Li₂O, Cs₂O, and/or K₂O; alkali metal halides, such as LiF, NaF, CsF, KF, Lil, Nal, Csl, and/or KI; or any combination thereof. The alkaline earth metal-containing compound may include an alkaline earth metal oxide, such as BaO, SrO, CaO, BaₓSr₁₋ₓO (wherein x is a real number satisfying the condition of 0<x<1), BaₓCa₁₋ₓO (wherein x is a real number satisfying the condition of 0<x<1), and/or the like. The rare earth metal-containing compound may include YbF₃, ScF₃, Sc₂O₃, Y₂O₃, Ce₂O₃, GdF₃, TbF₃, YbI₃, ScI₃, TbI₃, or any combination thereof. In one or more embodiments, the rare earth metal-containing compound may include lanthanide metal telluride. Examples of the lanthanide metal telluride may include LaTe, CeTe, PrTe, NdTe, PmTe, SmTe, EuTe, GdTe, TbTe, DyTe, HoTe, ErTe, TmTe, YbTe, LuTe, La₂Te₃, Ce₂Te₃, Pr₂Te₃, Nd₂Te₃, Pm₂Te₃, Sm₂Te₃, Eu₂Te₃, Gd₂Te₃, Tb₂Te₃, Dy₂Te₃, Ho₂Te₃, Er₂Te₃, Tm₂Te₃, Yb₂Te₃, Lu₂Te₃, or any combination thereof.

The alkali metal complex, the alkaline earth-metal complex, and the rare earth metal complex may include i) one selected from metal ions of the alkali metal, the alkaline earth metal, and the rare earth metal and ii), a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or any combination thereof.

The electron injection layer may include (e.g., consist of) an alkali metal, an alkaline earth metal, a rare earth metal, an alkali metal-containing compound, an alkaline earth metal-containing compound, a rare earth metal-containing compound, an alkali metal complex, an alkaline earth metal complex, a rare earth metal complex, or any combination thereof, as described above. In one or more embodiments, the electron injection layer may further include an organic material (for example, a compound represented by Formula 601).

In an embodiment, the electron injection layer may include (e.g., consist of) i) an alkali metal-containing compound (for example, alkali metal halide), ii) a) an alkali metal-containing compound (for example, alkali metal halide); and b) an alkali metal, an alkaline earth metal, a rare earth metal, or any combination thereof. For example, the electron injection layer may be a KI:Yb co-deposited layer, an RbI:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or any combination thereof may be homogeneously or non-homogeneously dispersed in a matrix including the organic material.

A thickness of the electron injection layer may be in a range of about 1 Å to about 100 Å, for example, about 3 Å to about 90 Å. When the thickness of the electron injection layer is within this range, suitable or satisfactory electron injection characteristics may be obtained without a substantial increase in driving voltage.

### Second electrode 150

The second electrode 150 may be on the interlayer 130 having a structure as described above. The second electrode 150 may be a cathode, which is an electron injection electrode, and a material for forming the second electrode 150 may include a metal, an alloy, an electrically conductive compound, or any combination thereof, each having a low-work function.

The second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or any combination thereof. The second electrode 150 may be a transmissive electrode, a semi-transmissive electrode, or a reflective electrode.

The second electrode 150 may have a single-layered structure or a multi-layered structure including a plurality of layers.

### Capping layer

A first capping layer may be outside the first electrode 110, and/or a second capping layer may be outside the second electrode 150. In more detail, the light-emitting device 10 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in an emission layer of the interlayer 130 of the light-emitting device 10 may be extracted toward the outside through the first electrode 110 which is a semi-transmissive electrode or a transmissive electrode, and the first capping layer. Light generated in an emission layer of the interlayer 130 of the light-emitting device 10 may be extracted toward the outside through the second electrode 150 which is a semi-transmissive electrode or a transmissive electrode, and the second capping layer.

The first capping layer and the second capping layer may increase external luminescence efficiency according to the principle of constructive interference. Accordingly, the light extraction efficiency of the light-emitting device 10 may be increased, so that the luminescence efficiency of the light-emitting device 10 may be improved.

Each of the first capping layer and the second capping layer may include a material having a refractive index of 1.6 or more (at a wavelength of 589 nm).

The first capping layer and the second capping layer may each independently be an organic capping layer including an organic material, an inorganic capping layer including an inorganic material, or an organic-inorganic composite capping layer including an organic material and an inorganic material.

At least one selected from the first capping layer and the second capping layer may each independently include a carbocyclic compound, a heterocyclic compound, an amine group-containing compound, a porphine derivative, a phthalocyanine derivative, a naphthalocyanine derivative, an alkali metal complex, an alkaline earth metal complex, or any combination thereof. The carbocyclic compound, the heterocyclic compound, and the amine group-containing compound may optionally be substituted with a substituent including O, N, S, Se, Si, F, Cl, Br, I, or any combination thereof. In an embodiment, at least one selected from the first capping layer and the second capping layer may each independently include an amine group-containing compound.

For example, at least one selected from the first capping layer and the second capping layer may each independently include a compound represented by Formula 201, a compound represented by Formula 202, or any combination thereof.

In one or more embodiments, at least one selected from the first capping layer and the second capping layer may each independently include one selected from Compounds HT28 to HT33, one selected from Compounds CP1 to CP7, β-NPB, or any combination thereof:

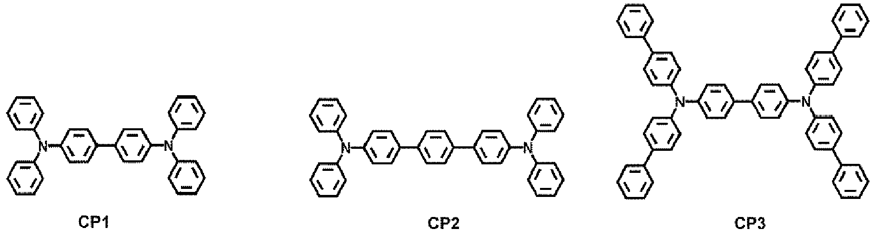

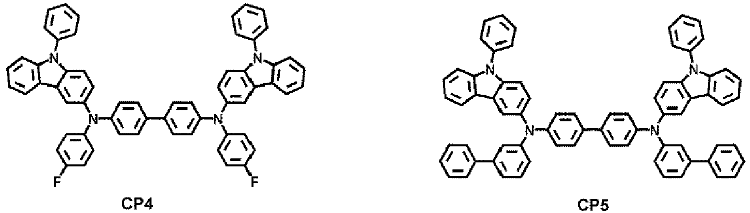

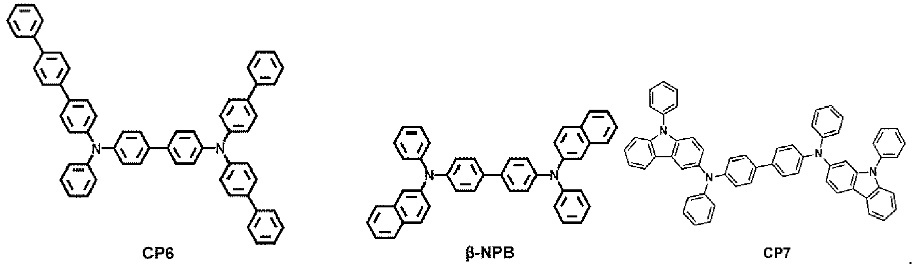

### Electronic apparatus

The light-emitting device may be included in various suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be in at least one traveling direction of light emitted from the light-emitting device. For example, the light emitted from the light-emitting device may be blue light or white light. For more details on the light-emitting device, related description provided above may be referred to. In an embodiment, the color conversion layer may include a quantum dot. The quantum dot may be, for example, a quantum dot as described herein.

The electronic apparatus may include a first substrate. The first substrate may include a plurality of subpixel areas, the color filter may include a plurality of color filter areas respectively corresponding to the plurality of subpixel areas, and the color conversion layer may include a plurality of color conversion areas respectively corresponding to the plurality of subpixel areas.

A pixel-defining layer may be located among the plurality of subpixel areas to define each of the plurality of subpixel areas.

The color filter may further include a plurality of color filter areas and light-shielding patterns located among the plurality of color filter areas, and the color conversion layer may further include a plurality of color conversion areas and light-shielding patterns located among the plurality of color conversion areas.

The plurality of color filter areas (or the plurality of color conversion areas) may include a first area that emits a first color light, a second area emitting second color light, and/or a third area that emits a third color light, wherein the first color light, the second color light, and/or the third color light may have different maximum emission wavelengths from one another. For example, the first color light may be red light, the second color light may be green light, and the third color light may be blue light. For example, the plurality of color filter areas (or the plurality of color conversion areas) may include quantum dots. In more detail, the first area may include a red quantum dot, the second area may include a green quantum dot, and the third area may not include a quantum dot. For more details on the quantum dot, related descriptions provided herein may be referred to. The first area, the second area, and/or the third area may each include a scatterer (e.g., a light scatterer).

For example, the light-emitting device may emit a first light, the first area may absorb the first light to emit a first-first color light, the second area may absorb the first light to emit a second-first color light, and the third area may absorb the first light to emit a third-first color light. In this regard, the first-first color light, the second-first color light, and the third-first color light may have different maximum emission wavelengths from one another. In more detail, the first light may be blue light, the first-first color light may be red light, the second-first color light may be green light, and the third-first color light may be blue light.

The electronic apparatus may further include a thin-film transistor, in addition to the light-emitting device as described above. The thin-film transistor may include a source electrode, a drain electrode, and an activation layer, wherein any one selected from the source electrode and the drain electrode may be electrically connected to any one selected from the first electrode and the second electrode of the light-emitting device.

The thin-film transistor may further include a gate electrode, a gate insulating film, and/or the like

The activation layer may include crystalline silicon, amorphous silicon, an organic semiconductor, an oxide semiconductor, and/or the like.

The electronic apparatus may further include a sealing portion for sealing the light-emitting device. The sealing portion may be between the color conversion layer and/or color filter and the light-emitting device. The sealing portion allows light from the light-emitting device to be extracted to the outside, and concurrently (e.g., simultaneously) prevents or reduces penetration of ambient air and/or moisture into the light-emitting device. The sealing portion may be a sealing substrate including a transparent glass substrate and/or a plastic substrate. The sealing portion may be a thin-film encapsulation layer including at least one layer of an organic layer and an inorganic layer. When the sealing portion is a thin-film encapsulation layer, the electronic apparatus may be flexible.

Various suitable functional layers may be additionally on the sealing portion, in addition to the color filter and/or the color conversion layer, according to the use of the electronic apparatus. Examples of the functional layers may include a touch screen layer, a polarizing layer, and the like. The touch screen layer may be a pressure-sensitive touch screen layer, a capacitive touch screen layer, and/or an infrared touch screen layer. The authentication apparatus may be, for example, a biometric authentication apparatus that authenticates an individual by using biometric information of a living body (for example, fingertips, pupils, etc.).

The authentication apparatus may further include, in addition to the light-emitting device as described above, a biometric information collector.

The electronic apparatus may be applied to various suitable displays, light sources, lighting apparatus, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, and/or endoscope displays), fish finders, various suitable measuring instruments, meters (for example, meters for a vehicle, an aircraft, and/or a vessel), projectors, and/or the like.

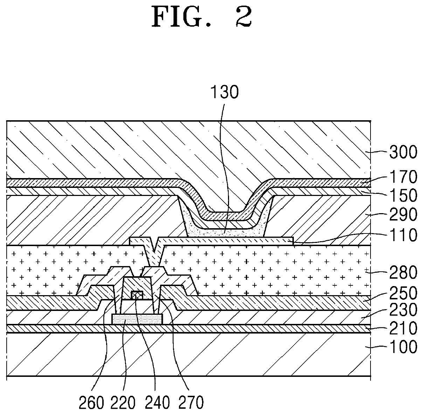

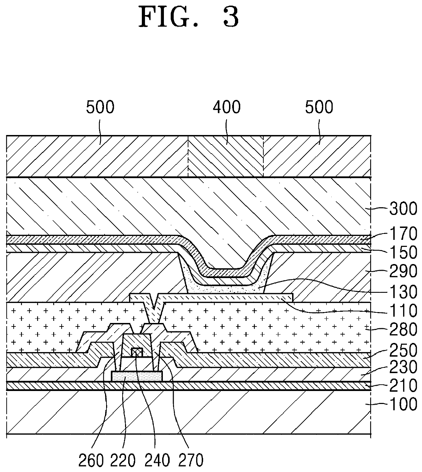

### Description of FIGS. 2 and 3

FIG. 2 is a cross-sectional view of a light-emitting apparatus according to an embodiment.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, and/or a metal substrate. A buffer layer 210 may be on the substrate 100. The buffer layer 210 may prevent or reduce penetration of impurities through the substrate 100 and may provide a flat surface on the substrate 100.

A TFT may be on the buffer layer 210. The TFT may include an activation layer 220, a gate electrode 240, a source electrode 260, and a drain electrode 270.

The activation layer 220 may include an inorganic semiconductor such as silicon and/or polysilicon, an organic semiconductor, and/or an oxide semiconductor, and may include a source region, a drain region, and a channel region.

A gate insulating film 230 for insulating the activation layer 220 from the gate electrode 240 may be on the activation layer 220, and the gate electrode 240 may be on the gate insulating film 230.

An interlayer insulating film 250 may be on the gate electrode 240. The interlayer insulating film 250 may be between the gate electrode 240 and the source electrode 260 and between the gate electrode 240 and the drain electrode 270 to provide insulation therebetween.

The source electrode 260 and the drain electrode 270 may be on the interlayer insulating film 250. The interlayer insulating film 250 and the gate insulating film 230 may expose the source region and the drain region of the activation layer 220, and the source electrode 260 and the drain electrode 270 may be in contact (e.g., physical contact) with the exposed portions of the source region and the drain region of the activation layer 220.

The TFT is electrically connected to a light-emitting device to drive the light-emitting device, and is covered and protected by a passivation layer 280. The passivation layer 280 may include an inorganic insulating film, an organic insulating film, or any combination thereof. A light-emitting device is provided on the passivation layer 280. The light-emitting device includes a first electrode 110, an interlayer 130, and a second electrode 150.

The first electrode 110 may be on the passivation layer 280. The passivation layer 280 may not completely cover the drain electrode 270 and expose a portion of the drain electrode 270, and the first electrode 110 may be connected to the exposed portion of the drain electrode 270.

A pixel defining layer 290 including an insulating material may be on the first electrode 110. The pixel defining layer 290 may expose a portion of the first electrode 110, and an interlayer 130 may be formed in the exposed portion of the first electrode 110. The pixel defining layer 290 may be a polyimide organic film and/or a polyacrylic organic film. In some embodiments, at least some layers of the interlayer 130 may extend beyond the upper portion of the pixel defining layer 290 in the form of a common layer.

The second electrode 150 may be on the interlayer 130, and a capping layer 170 may be additionally on the second electrode 150. The capping layer 170 may cover the second electrode 150.

The encapsulation portion 300 may be on the capping layer 170. The encapsulation portion 300 may be on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or any combination thereof; an organic film including polyethylene terephthalate, polyethylene naphthalate, polycarbonate, polyimide, polyethylene sulfonate, polyoxymethylene, polyarylate, hexamethyldisiloxane, an acrylic-based resin (for example, polymethyl methacrylate, polyacrylic acid, etc.), an epoxy-based resin (for example, aliphatic glycidyl ether (AGE), etc.), or any combination thereof; or any combination of the inorganic films and the organic films.

FIG. 3 is a cross-sectional view of a light-emitting apparatus according to another embodiment.

The light-emitting apparatus of FIG. 3 is substantially the same as the light-emitting apparatus of FIG. 2, except that a light-shielding pattern 500 and a functional region 400 are additionally on the encapsulation portion 300. The functional region 400 may be i) a color filter area, ii) a color conversion area, or iii) a combination of the color filter area and the color conversion area. In an embodiment, the light-emitting device included in the light-emitting apparatus of FIG. 3 may be a tandem light-emitting device.

### Manufacturing method

Respective layers included in the hole transport region, the emission layer, and respective layers included in the electron transport region may be formed in a certain region by using one or more suitable methods selected from vacuum deposition, spin coating, casting, Langmuir-Blodgett (LB) deposition, ink-jet printing, laser-printing, laser-induced thermal imaging, and the like.

When layers included in the hole transport region, the emission layer, and layers included in the electron transport region are formed by vacuum deposition, the vacuum deposition may be performed at a deposition temperature of about 100 °C to about 500 °C, a vacuum degree of about 10⁻⁸ torr to about 10⁻³ torr, and a deposition speed of about 0.01 Å/sec to about 100 Å/sec, depending on a material to be included in a layer to be formed and the structure of a layer to be formed.

### Definition of Terms

The term "C₃-C₆₀ carbocyclic group," as used herein, refers to a cyclic group consisting of carbon atom only as a ring-forming atom and having 3 to 60 carbon atoms, and the term "C₁-C₆₀ heterocyclic group," as used herein, refers to a cyclic group that has 1 to 60 carbon atoms and further has, in addition to carbon atoms, a heteroatom as a ring-forming atom. The C₃-C₆₀ carbocyclic group and the C₁-C₆₀ heterocyclic group may each be a monocyclic group consisting of one ring or a polycyclic group in which two or more rings are condensed together with each other. For example, the C₁-C₆₀ heterocyclic group may have 3 to 61 ring-forming atoms.

The term "cyclic group," as used herein, may include both the C₃-C₆₀ carbocyclic group and the C₁-C₆₀ heterocyclic group.

The term "π electron-rich C₃-C₆₀ cyclic group," as used herein, refers to a cyclic group that has 3 to 60 carbon atoms and does not include *-N=*' as a ring-forming moiety. The term "π electron-deficient nitrogen-containing C₁-C₆₀ cyclic group," as used herein, refers to a heterocyclic group that has 1 to 60 carbon atoms and includes *-N=*' as a ring-forming moiety.

For example,
the C₃-C₆₀ carbocyclic group may be i) a T1 group or ii) a condensed cyclic group in which two or more T1 groups are condensed together with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),
the C₁-C₆₀ heterocyclic group may be i) a T2 group, ii) a condensed cyclic group in which at least two T2 groups are condensed together with each other, or iii) a condensed cyclic group in which at least one T2 group and at least one T1 group are condensed together with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
the π electron-rich C₃-C₆₀ cyclic group may be i) a T1 group, ii) a condensed cyclic group in which at least two T1 groups are condensed together with each other, iii) a T3 group, iv) a condensed cyclic group in which at least two T3 groups are condensed together with each other, or v) a condensed cyclic group in which at least one T3 group and at least one T1 group are condensed together with each other (for example, the C₃-C₆₀ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, etc.),
the π electron-deficient nitrogen-containing C₁-C₆₀ cyclic group may be i) a T4 group, ii) a condensed cyclic group in which at least two T4 groups are condensed together with each other, iii) a condensed cyclic group in which at least one T4 group and at least one T1 group are condensed together with each other, iv) a condensed cyclic group in which at least one T4 group and at least one T3 group are condensed together with each other, or v) a condensed cyclic group in which at least one T4 group, at least one T1 group, and at least one T3 group are condensed together with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, etc.),
wherein the T1 group may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or bicyclo[2.2.1]heptane) group, a norbornene group, a bicyclo[1.1.1]pentane group, a bicyclo[2.1.1]hexane group, a bicyclo[2.2.2]octane group, or a benzene group,
the T2 group may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,
the T3 group may be a furan group, a thiophene group, a 1H-pyrrole group, a silole group, or a borole group, and
the T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group," "the C₃-C₆₀ carbocyclic group," "the C₁-C₆₀ heterocyclic group," "the π electron-rich C₃-C₆₀ cyclic group," or "the π electron-deficient nitrogen-containing C₁-C₆₀ cyclic group," as used herein, refer to a group condensed to any cyclic group, a monovalent group, or a polyvalent group (for example, a divalent group, a trivalent group, a tetravalent group, etc.) according to the structure of a formula for which the corresponding term is used. For example, the "benzene group" may be a benzo group, a phenyl group, a phenylene group, or the like, which may be easily understood by one of ordinary skill in the art according to the structure of a formula including the "benzene group."

Examples of the monovalent C₃-C₆₀ carbocyclic group and the monovalent C₁-C₆₀ heterocyclic group may include a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, and a monovalent non-aromatic condensed heteropolycyclic group, and examples of the divalent C₃-C₆₀ carbocyclic group and the divalent C₁-C₆₀ heterocyclic group are a C₃-C₁₀ cycloalkylene group, a C₁-C₁₀ heterocycloalkylene group, a C₃-C₁₀ cycloalkenylene group, a C₁-C₁₀ heterocycloalkenylene group, a C₆-C₆₀ arylene group, a C₁-C₆₀ heteroarylene group, a divalent non-aromatic condensed polycyclic group, and a divalent non-aromatic condensed heteropolycyclic group.

The term "C₁-C₆₀ alkyl group," as used herein, for example, C₁-C₂₀ alkyl group, refers to a linear or branched aliphatic hydrocarbon monovalent group that has 1 to 60 carbon atoms, and examples thereof include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "C₁-C₆₀ alkylene group," as used herein, refers to a divalent group having substantially the same structure as the C₁-C₆₀ alkyl group. Corresponding definitions apply to other ranges given for the number of carbon atoms in an alkyl/alkylene group.

The term "C₂-C₆₀ alkenyl group," as used herein, refers to a monovalent hydrocarbon group having at least one carbon-carbon double bond at a main chain (e.g., in the middle) or at a terminal end (e.g., the terminus) of the C₂-C₆₀ alkyl group, and examples thereof include an ethenyl group, a propenyl group, and a butenyl group. The term "C₂-C₆₀ alkenylene group," as used herein, refers to a divalent group having substantially the same structure as the C₂-C₆₀ alkenyl group. Corresponding definitions apply to other ranges given for the number of carbon atoms in an alkenyl/alkenylene group.

The term "C₂-C₆₀ alkynyl group," as used herein, refers to a monovalent hydrocarbon group having at least one carbon-carbon triple bond at a main chain (e.g., in the middle) or at a terminal end (e.g., the terminus) of the C₂-C₆₀ alkyl group, and examples thereof include an ethynyl group and a propynyl group. The term "C₂-C₆₀ alkynylene group," as used herein, refers to a divalent group having substantially the same structure as the C₂-C₆₀ alkynyl group. Corresponding definitions apply to other ranges given for the number of carbon atoms in an alkynyl/alkynylene group.

The term "C₁-C₆₀ alkoxy group," as used herein, refers to a monovalent group represented by -OA₁₀₁ (wherein A₁₀₁ is the C₁-C₆₀ alkyl group), and examples thereof include a methoxy group, an ethoxy group, and an isopropyloxy group. Corresponding definitions apply to other ranges given for the number of carbon atoms in an alkoxy group.

The term "C₃-C₁₀ cycloalkyl group," as used herein, refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "C₃-C₁₀ cycloalkylene group," as used herein, refers to a divalent group having substantially the same structure as the C₃-C₁₀ cycloalkyl group.

The term "C₁-C₁₀ heterocycloalkyl group," as used herein, refers to a monovalent cyclic group of 1 to 10 carbon atoms, further including, in addition to carbon atoms, at least one heteroatom, as ring-forming atoms, and examples include a 1,2,3,4-oxatriazolidinyl group, a tetrahydrofuranyl group, and a tetrahydrothienyl group. The term "C₁-C₁₀ heterocycloalkylene group," as used herein, refers to a divalent group having substantially the same structure as the C₁-C₁₀ heterocycloalkyl group.

The term "C₃-C₁₀ cycloalkenyl group," as used herein, refers to a monovalent cyclic group that has 3 to 10 carbon atoms and at least one carbon-carbon double bond in the ring thereof and no aromaticity (e.g., is not aromatic), and examples thereof include a cyclopentenyl group, a cyclohexenyl group, and a cycloheptenyl group. The term "C₃-C₁₀ cycloalkenylene group," as used herein, refers to a divalent group having substantially the same structure as the C₃-C₁₀ cycloalkenyl group.

The term "C₁-C₁₀ heterocycloalkenyl group," as used herein, refers to a monovalent cyclic group of 1 to 10 carbon atoms, further including, in addition to carbon atoms, at least one heteroatom, as ring-forming atoms, and having at least one double bond in the cyclic structure thereof. Examples of the C₁-C₁₀ heterocycloalkenyl group include a 4,5-dihydro-1,2,3,4-oxatriazolyl group, a 2,3-dihydrofuranyl group, and a 2,3-dihydrothienyl group. The term "C₁-C₁₀ heterocycloalkenylene group," as used herein, refers to a divalent group having substantially the same structure as the C₁-C₁₀ heterocycloalkenyl group.

The term "C₆-C₆₀ aryl group," as used herein, refers to a monovalent group having a carbocyclic aromatic system of 6 to 60 carbon atoms, and the term "C₆-C₆₀ arylene group," as used herein, refers to a divalent group having a carbocyclic aromatic system of 6 to 60 carbon atoms. Examples of the C₆-C₆₀ aryl group include a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the C₆-C₆₀ aryl group and the C₆-C₆₀ arylene group each include two or more rings, the two or more rings may be condensed together with each other. Corresponding definitions apply to other ranges given for the number of carbon atoms in an aryl/arylene group.

The term "C₁-C₆₀ heteroaryl group," as used herein, refers to a monovalent group having a heterocyclic aromatic system of 1 to 60 carbon atoms, further including, in addition to carbon atoms, at least one heteroatom, as ring-forming atoms. The term "C₁-C₆₀ heteroarylene group," as used herein, refers to a divalent group having a heterocyclic aromatic system of 1 to 60 carbon atoms, further including, in addition to carbon atoms, at least one heteroatom, as ring-forming atoms. Examples of the C₁-C₆₀ heteroaryl group include a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the C₁-C₆₀ heteroaryl group and the C₁-C₆₀ heteroarylene group each include two or more rings, the two or more rings may be condensed together with each other. Corresponding definitions apply to other ranges given for the number of carbon atoms in an heteroaryl/heteroarylene group.

The term "monovalent non-aromatic condensed polycyclic group," as used herein, refers to a monovalent group (for example, having 8 to 60 carbon atoms) having two or more rings condensed to each other, only carbon atoms as ring-forming atoms, and no aromaticity in its entire molecular structure (e.g., is not aromatic when considered as a whole). Examples of the monovalent non-aromatic condensed polycyclic group are an indenyl group, a fluorenyl group, a spiro-bifluorenyl group, a benzofluorenyl group, an indenophenanthrenyl group, and an indeno anthracenyl group. The term "divalent non-aromatic condensed polycyclic group," as used herein, refers to a divalent group having substantially the same structure as the monovalent non-aromatic condensed polycyclic group described above.

The term "monovalent non-aromatic condensed heteropolycyclic group," as used herein, refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure (e.g., is not aromatic when considered as a whole). Examples of the monovalent non-aromatic condensed heteropolycyclic group include a pyrrolyl group, a thienyl group, a furanyl group, an indolyl group, a benzoindolyl group, a naphtho indolyl group, an isoindolyl group, a benzoisoindolyl group, a naphthoisoindolyl group, a benzosilolyl group, a benzothienyl group, a benzofuranyl group, a carbazolyl group, a dibenzosilolyl group, a dibenzothienyl group, a dibenzofuranyl group, an azacarbazolyl group, an azafluorenyl group, an azadibenzosilolyl group, an azadibenzothienyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indenocarbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothienyl group, a benzonaphthosilolyl group, a benzofurodibenzofuranyl group, a benzofurodibenzothienyl group, and a benzothienodibenzothienyl group. The term "divalent non-aromatic condensed heteropolycyclic group," as used herein, refers to a divalent group having substantially the same structure as the monovalent non-aromatic condensed heteropolycyclic group described above.

The term "C₆-C₆₀ aryloxy group," as used herein, indicates -OA₁₀₂ (wherein A₁₀₂ is a C₆-C₆₀ aryl group), and the term "C₆-C₆₀ arylthio group," as used herein, indicates -SA₁₀₃ (wherein A₁₀₃ is a C₆-C₆₀ aryl group). Corresponding definitions apply to other ranges given for the number of carbon atoms in an aryloxy group and an arylthio group.

The term "C₇₋C₆₀ aryl alkyl group," as used herein, refers to -A₁₀₄A₁₀₅ (wherein A₁₀₄ is a C₁-C₅₄ alkylene group, and A₁₀₅ is a C₆-C₅₉ aryl group). The term "C₂-C₆₀ heteroaryl alkyl group," as used herein, refers to -A₁₀₆A₁₀₇ (wherein A₁₀₆ is a C₁-C₅₉ alkylene group, and A₁₀₇ is a C₁-C₅₉ heteroaryl group).

The term "R₁₀ₐ," as used herein, refers to:
deuterium (-D), -F, -Cl, -Br, -I, a hydroxyl group, a cyano group, or a nitro group,
a C₁-C₆₀ (*e*.*g*. C₁-C₂₀) alkyl group, a C₂-C₆₀ (*e.g*. C₂-C₂₀) alkenyl group, a C₂-C₆₀ (*e*.*g*. C₂-C₂₀) alkynyl group, or a C₁-C₆₀ (*e*.*g*. C₁-C₂₀) alkoxy group, each unsubstituted or substituted with deuterium, -F, -Cl, -Br, -I, a hydroxyl group, a cyano group, a nitro group, a C₃-C₆₀ (*e*.*g*. C₃-C₃₀) carbocyclic group, a C₁-C₆₀ (*e*.*g*. C₁-C₂₀) heterocyclic group, a C₆-C₆₀ (*e*.*g*. C₆-C₃₀) aryloxy group, a C₆-C₆₀ (*e*.*g*. C₆-C₃₀) arylthio group, a C₇-C₆₀ (*e*.*g*. C₇-C₃₀) aryl alkyl group, a C₂-C₆₀ (*e*.*g*. C₂-C₂₀) heteroaryl alkyl group, -Si(Q₁₁₎(Q₁₂)(Q₁₃), -N(Q₁₁)(Q₁₂), -B(Q₁₁)(Q₁₂), -C(=O)(Q₁₁), -S(=O)₂(Q₁₁), - P(=O)(Q₁₁)(Q₁₂), or any combination thereof,
a C₃-C₆₀ (*e*.*g*. C₃-C₃₀) carbocyclic group, a C₁-C₆₀ (*e*.*g*. C₁-C₂₀) heterocyclic group, a C₆-C₆₀ (*e*.*g*. C₆-C₃₀) aryloxy group, a C₆-C₆₀ (*e*.*g*. C₆-C₃₀) arylthio group, a C₇-C₆₀ (*e*.*g*. C₇-C₃₀) arylalkyl group, or a C₂-C₆₀ (*e*.*g*. C₂-C₂₀) heteroarylalkyl group, each unsubstituted or substituted with deuterium, -F, -Cl, -Br, -I, a hydroxyl group, a cyano group, a nitro group, a C₁-C₆₀ (*e*.*g*. C₁-C₂₀) alkyl group, a C₂-C₆₀ (*e*.*g*. C₂-C₂₀) alkenyl group, a C₂-C₆₀ (*e*.*g*. C₂-C₂₀) alkynyl group, a C₁-C₆₀ (*e*.*g*. C₁-C₂₀) alkoxy group, a C₃-C₆₀ (*e*.*g*. C₃-C₃₀) carbocyclic group, a C₁-C₆₀ (*e*.*g*. C₁-C₂₀) heterocyclic group, a C₆-C₆₀ (*e*.*g*. C₆-C₃₀) aryloxy group, a C₆-C₆₀ (*e*.*g*. C₆-C₃₀) arylthio group, a C₇-C₆₀ (*e*.*g*. C₇-C₃₀) arylalkyl group, a C₂-C₆₀ (*e*.*g*. C₂-C₂₀) heteroarylalkyl group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂).

Q₁ to Q₃, Q₁₁ to Q₁₃, Q₂₁ to Q₂₃, and Q₃₁ to Q₃₃ as used herein may each independently be: hydrogen; deuterium; -F; -Cl; -Br; -I; a hydroxyl group; a cyano group; a nitro group; a C₁-C₆₀ (*e*.*g*. C₁-C₂₀) alkyl group, a C₂-C₆₀ (*e*.*g*. C₂-C₂₀) alkenyl group, a C₂-C₆₀ (*e*.*g*. C₂-C₂₀) alkynyl group, a C₁-C₆₀ (*e*.*g*. C₁-C₂₀) alkoxy group, a C₃-C₆₀ (*e*.*g*. C₃-C₃₀) carbocyclic group or a C₁-C₆₀ (*e*.*g*. C₁-C₂₀) heterocyclic group, each unsubstituted or substituted with deuterium, -F, a cyano group, a C₁-C₆₀ (*e*.*g*. C₁-C₂₀) alkyl group, a C₁-C₆₀ (*e*.*g*. C₁-C₂₀) alkoxy group, a phenyl group, a biphenyl group, or any combination thereof; a C₇-C₆₀ (*e*.*g*. C₇-C₃₀) arylalkyl group; or a C₂-C₆₀ (*e*.*g*. C₂-C₂₀) heteroarylalkyl group.

The term "heteroatom," as used herein, refers to any atom other than a carbon atom. Examples of the heteroatom include O, S, N, P, Si, B, Ge, Se, or any combinations thereof.

The term "third-row transition metal," as used herein, includes hafnium (Hf), tantalum (Ta), tungsten (W), rhenium (Re), osmium (Os), iridium (Ir), platinum (Pt), gold (Au), and the like.

The term "Ph", as used herein, refers to a phenyl group, the term "Me" refers to a methyl group, the term "Et" refers to an ethyl group, the term "tert-Bu" or "Bu^{t}" refers to a tert-butyl group, and the term "OMe" refers to a methoxy group.

The term "biphenyl group," as used herein, refers to "a phenyl group substituted with a phenyl group". In other words, the "biphenyl group" belongs to "a substituted phenyl group having a C₆-C₆₀ aryl group as a substituent".

The term "terphenyl group," as used herein, refers to "a phenyl group substituted with a biphenyl group." In other words, the "terphenyl group" belongs to "a substituted phenyl group having, as a substituent, a C₆-C₆₀ aryl group substituted with a C₆-C₆₀ aryl group".

* and *', as used herein, unless defined otherwise, each refer to a binding site to a neighboring atom in a corresponding formula or moiety.

Hereinafter, a compound and light-emitting device according to embodiments will be described in more detail with reference to Examples. The wording "B was used instead of A" used in describing Synthesis Examples means that an identical molar equivalent of B was used in place of A.

### Examples

### Evaluation Example 1: T₁ and HOMO energy level

The lowest excitation triplet energy level (T₁) and HOMO energy level of the following compounds were evaluated through the method described above, and the results thereof are shown in Table 1.

**Table 1**

| Compound | T₁ of compound (eV) | HOMO energy level of compound (eV) |
|---|---|---|
| 1-1 | 2.61 | -4.68 |
| 1-2 | 2.61 | -4.74 |
| 1-3 | 2.68 | -4.81 |
| 1-4 | 2.68 | -4.84 |
| 2-1 | 2.77 | -4.96 |
| 2-2 | 2.77 | -4.99 |
| A | 2.73 | -4.89 |
| B | 2.66 | -4.79 |
| C | 2.83 | -4.96 |
| D | 2.51 | -4.97 |
| E | 2.40 | -5.02 |

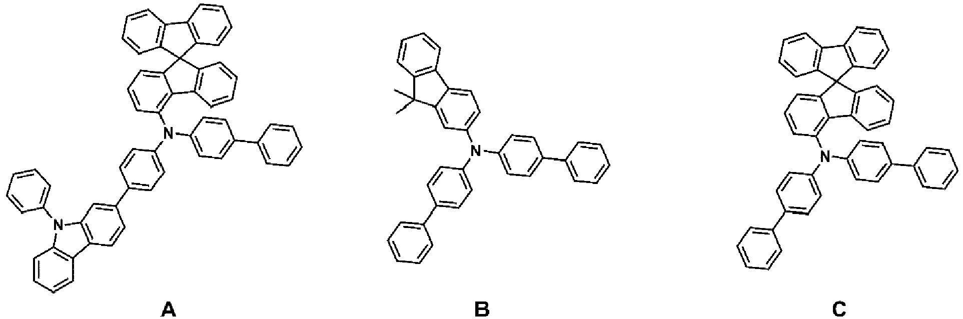

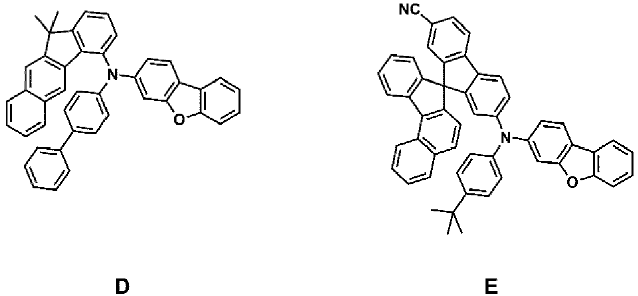

Referring to Table 1, it can be seen that compounds 1-1 to 1-4 and compounds 2-1 and 2-2 had an appropriate T₁ energy and HOMO energy for excellent hole injection and hole transport ability.

### Example 1

As an ITO anode, ITO/Ag/ITO were patterned on a glass substrate to a thickness of each 10 nm, 120 nm, and 8 nm, respectively, and oxygen plasma treatment was performed thereon, followed by exposure to argon plasma for cleaning. Then, the glass substrate was installed in a vacuum deposition apparatus.

HT3 and PDM were co-deposited on the ITO anode formed on the glass substrate at a weight ratio of 99 : 1 to form a hole injection layer having a thickness of 10 nm, and then, HT3 was vacuum-deposited on the hole injection layer to form a hole transport layer having a thickness of 130 nm.

Compound 1-1 was vacuum-deposited on the hole transport layer to form a first layer having a thickness of 25 nm, and Compound 2-1 was vacuum-deposited on the first layer to form a second layer having a thickness of 5 nm.

H125, H126, and PD40 were co-deposited at a weight ratio of 32.2 : 59.8 : 8 on the second layer to form an emission layer having a thickness of 35 nm.

Next, ET37 was deposited on the emission layer to form a hole blocking layer having a thickness of 5 nm, ET46 and Liq were co-deposited on the hole blocking layer at a weight ratio of 50 : 50 to form an electron transport layer having a thickness of 31 nm, Yb was deposited on the electron transport layer to form an electron injection layer having a thickness of 1.5 nm, Ag and Mg were co-deposited on the electron injection layer at a weight ratio of 91 : 9 to form a cathode having a thickness of 12 nm, and CP7 was vacuum-deposited on the cathode to form a capping layer having a thickness of 80 nm, thereby completing the manufacture of a light-emitting device.

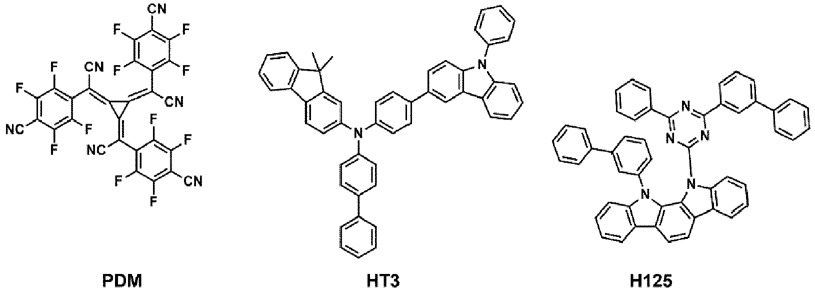

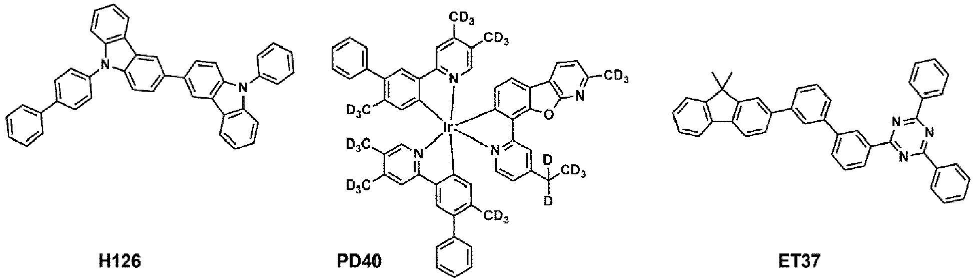

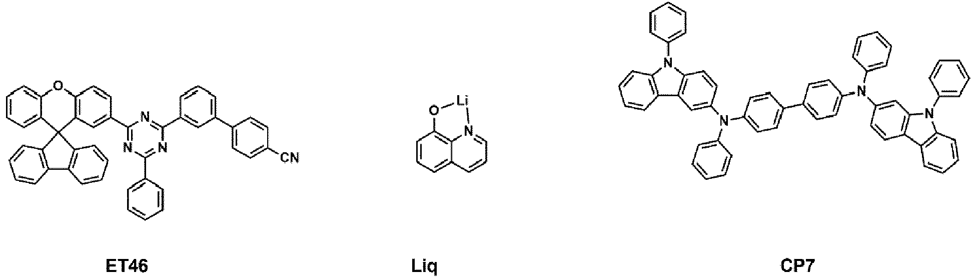

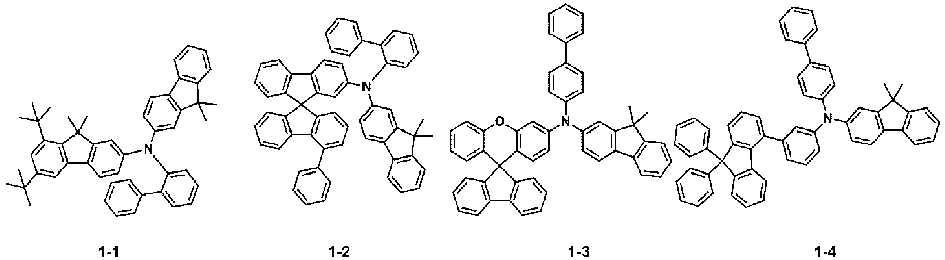

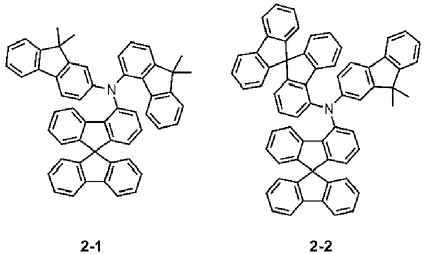

### Examples 2 to 5 and Comparative Examples 3 to 6

Light-emitting devices were manufactured in substantially the same manner as in Example 1, except that, in forming the first layer, corresponding compounds shown in Table 2 were used instead of Compound 1-1, and that, in forming the second layer, corresponding compounds shown in Table 2 were used instead of Compound 2-1.

### Comparative Example 1

A light-emitting device was manufactured in substantially the same manner as in Example 1, except that Compound 1-1 was vacuum-deposited on the hole transport layer to form a first layer with having a thickness of 30 nm, and that H125, H126, and PD40 were co-deposited at a weight ratio of 32.2 : 59.8 : 8 on the first layer to form an emission layer having a thickness of 35 nm.

### Comparative Example 2

A light-emitting device was manufactured in substantially the same manner as in Example 1, except that Compound 2-1 was vacuum-deposited on the hole transport layer to form a first layer with having a thickness of 30 nm, and that H125, H126, and PD40 were co-deposited at a weight ratio of 32.2 : 59.8 : 8 on the first layer to form an emission layer having a thickness of 35 nm.

### Evaluation Example 2

To evaluate the characteristics of the light-emitting devices manufactured in Examples 1 to 5 and Comparative Examples 1 to 6, the luminescence efficiency and lifespan of each of the light-emitting devices were measured by calculation based on current-voltage-luminance characteristics assuming Lambertian radiation characteristics. The emission spectrum of each of the light-emitting devices was measured at the luminance of 15,000 cd/m², and CIE x and y coordinates (i.e., CIE x/y) were measured therefrom. In addition, the driving voltage and luminescence efficiency of each of the light-emitting devices were measured at the current density of 10 mA/cm² by using a source meter (Keithley Instrument Inc., 2400 series) and a luminescence efficiency measurement apparatus, C9920-2-12 of Hamamatsu Photonics Inc., respectively. In evaluating the luminescence efficiency, the luminance/current density was measured using a luminance meter that was calibrated for wavelength sensitivity, and the lifespan (T₉₇) was measured as the time taken to reach 97% of the initial luminance at the brightness b0 of 30,000 cd/m². The evaluation results of the characteristics of the light-emitting devices are shown in Table 2.

**Table 2**

| | First layer | Second layer | Driving Voltage [V] | Luminescence efficiency [cd/A] | CIEx/y | T₉₇ [h] |
|---|---|---|---|---|---|---|
| Example 1 | Compound 1-1 | Compound 2-1 | 4.04 | 175 | 0.26/0.71 | 260 |
| Example 2 | Compound 1-2 | Compound 2-1 | 4.31 | 167 | 0.25/0.72 | 290 |
| Example 3 | Compound 1-3 | Compound 2-1 | 4.30 | 173 | 0.26/0.71 | 249 |
| Example 4 | Compound 1-4 | Compound 2-1 | 4.29 | 172 | 0.25/0.71 | 229 |
| Example 5 | Compound 1-1 | Compound 2-2 | 4.27 | 183 | 0.27/0.70 | 220 |
| Comparative Example 1 | Compound 1-1 / 30 nm | | 3.84 | 171 | 0.26/0.71 | 166 |
| Comparative Example 2 | Compound 2-1 / 30 nm | | 4.49 | 175 | 0.26/0.71 | 277 |
| Comparative Example 3 | Compound A | Compound B | 4.50 | 160 | 0.25/0.72 | 200 |
| Comparative Example 4 | Compound C | Compound B | 4.40 | 155 | 0.25/0.72 | 200 |
| Comparative Example 5 | Compound D | Compound E | 4.30 | 150 | 0.25/0.72 | 150 |
| Comparative Example 6 | Compound B | Compound D | 4.75 | 153 | 0.25/0.72 | 180 |

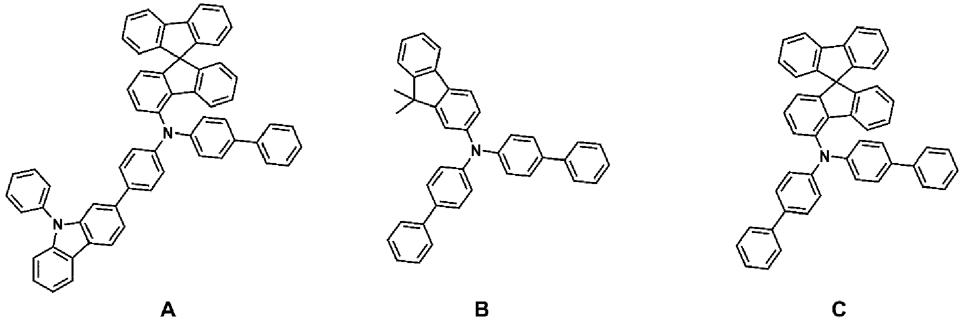

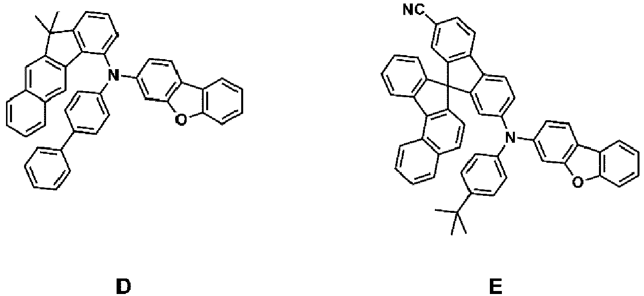

Referring to Table 2, it can be seen that the light-emitting devices of Examples 1 to 5 had a low driving voltage, excellent luminescence efficiency, and an excellent lifespan, as compared with the light-emitting devices of Comparative Examples 1 to 6.

According to an embodiment of the present disclosure, provided is a light-emitting device including a first layer and a second layer respectively including a first amine-based compound and a second amine-based compound that are different from each other, the first layer and the second layer being included in a hole transport region. Because at least one selected from the first amine-based compound and the second amine-based compound includes two or more fluorene moieties, injection of holes in an emission layer may be controlled, thereby realizing a light-emitting device having a low driving voltage, high light-emission efficiency, and a long lifespan.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the following claims, and equivalents thereof.

## Claims

1. A light-emitting device comprising:
a first electrode;
a second electrode facing the first electrode; and
an interlayer between the first electrode and the second electrode and comprising an emission layer, wherein:
the interlayer further comprises a hole transport region between the emission layer and the first electrode,
the hole transport region comprises a first layer and a second layer, the second layer between the first layer and the emission layer,
the first layer comprises a first amine-based compound,
the second layer comprises a second amine-based compound,
the first amine-based compound and the second amine-based compound are different from each other, and
at least one selected from Conditions 1-1 to 1-3 is satisfied:
Condition 1-1
the first amine-based compound comprises two or more fluorene moieties;
Condition 1-2
the second amine-based compound comprises two or more fluorene moieties; and
Condition 1-3
the first amine-based compound and the second amine-based compound each comprise two or more fluorene moieties.

2. The light-emitting device of claim 1, wherein the hole transport region further comprises a hole transport layer, and
the hole transport layer is in direct contact with the first layer.

3. The light-emitting device of claim 1 or claim 2, wherein:
(i) the first layer is in direct contact with the second layer; and/or
(ii) the emission layer emits green light.

4. The light-emitting device of any one of claims 1 to 3, wherein:
(i) the first layer consists of the first amine-based compound; and/or
(ii) a lowest excitation triplet energy level of the second amine-based compound is 2.65 eV or more.

5. The light-emitting device of any one of claims 1 to 4, wherein:
(i) a highest occupied molecular orbital energy level of the first amine-based compound is -4.50 eV or less; and/or
(ii) a highest occupied molecular orbital energy level of the second amine-based compound is -4.50 eV or less.

6. The light-emitting device of any one of claims 1 to 5, wherein the fluorene moieties are each a group represented by Formula A or a group represented by Formula B: 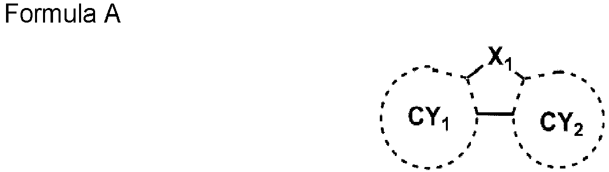 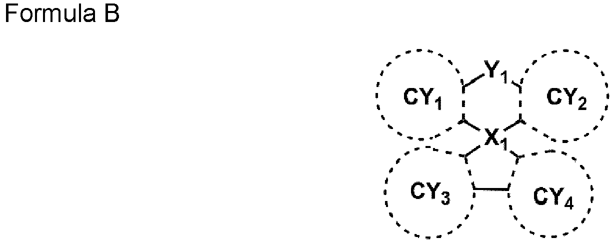 wherein, in Formulae A and B,
CY₁ to CY₄ are each independently a C₅-C₆₀ carbocyclic group or a C₁-C₆₀ heterocyclic group,
X₁ is a group including C, and
Y₁ is a non-bond, a single bond, O, or S.

7. The light-emitting device of any one of claims 1 to 6, wherein the first amine-based compound and the second amine-based compound both comprise the fluorene moieties.

8. The light-emitting device of any one of claims 1 to 7, wherein the first amine-based compound is represented by Formula 1, and
the second amine-based compound is represented by Formula 2: 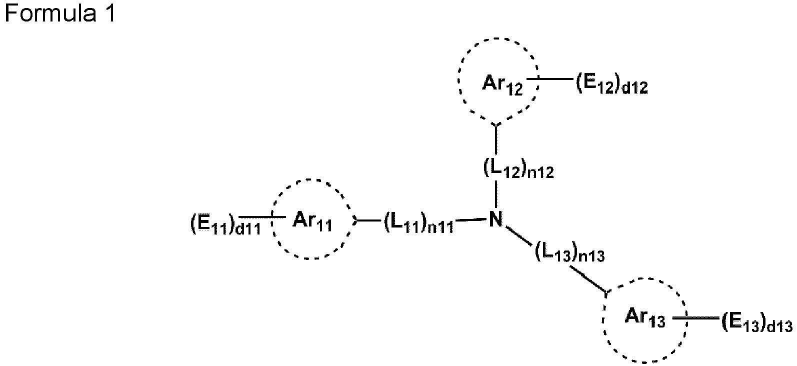 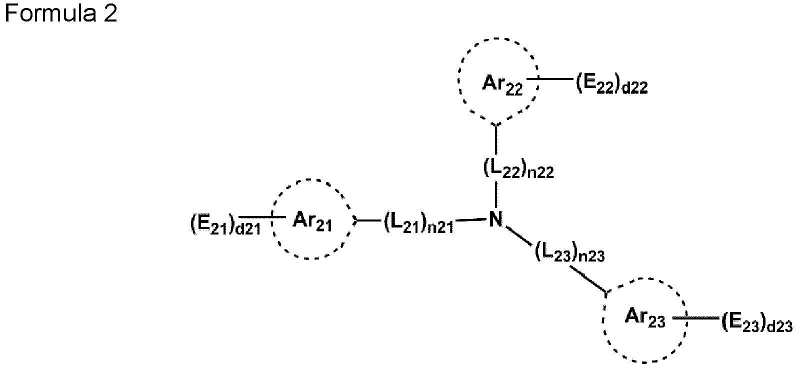 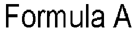 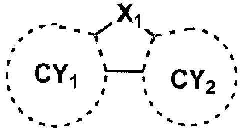 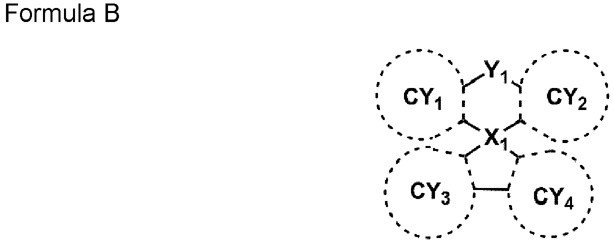 wherein, in Formulae 1 and 2,
Ar₁₁ and Ar₂₁ are each independently a group represented by Formula A or a group represented by Formula B,
Ar₁₂, Ar₁₃, Ar₂₂, and Ar₂₃ are each independently a C₅-C₆₀ carbocyclic group, a C₁-C₆₀ heterocyclic group, a group represented by Formula A, or a group represented by Formula B,
at least one selected from Ar₁₂ and Ar₂₂ is a group represented by Formula A or a group represented by Formula B,
L₁₁ to L₁₃ and L₂₁ to L₂₃ are each independently a single bond, a C₅-C₆₀ carbocyclic group unsubstituted or substituted with at least one R₁₀ₐ, or a C₁-C₆₀ heterocyclic group unsubstituted or substituted with at least one R₁₀ₐ,
n11 to n13 and n21 to n23 are each independently an integer selected from 1 to 3,
E₁₁ to E₁₃ and E₂₁ to E₂₃ are each independently hydrogen, deuterium, -F, -Cl, - Br, -I, a hydroxyl group, a cyano group, a nitro group, a C₁-C₆₀ alkyl group unsubstituted or substituted with at least one R₁₀ₐ, a C₂-C₆₀ alkenyl group unsubstituted or substituted with at least one R₁₀ₐ, a C₂-C₆₀ alkynyl group unsubstituted or substituted with at least one R₁₀ₐ, a C₁-C₆₀ alkoxy group unsubstituted or substituted with at least one R₁₀ₐ, a C₃-C₆₀ carbocyclic group unsubstituted or substituted with at least one R₁₀ₐ, a C₁-C₆₀ heterocyclic group unsubstituted or substituted with at least one R₁₀ₐ, a C₆-C₆₀ aryloxy group unsubstituted or substituted with at least one R₁₀ₐ, a C₆-C₆₀ arylthio group unsubstituted or substituted with at least one R₁₀ₐ, -Si(Q₁)(Q₂)(Q₃), -B(Q₁)(Q₂), - C(=O)(Q₁), -S(=O)₂(Q₁), or -P(=O)(Q₁)(Q₂),
d11 to d13 and d21 to d23 are each independently an integer selected from 0 to 10,
wherein, in Formulae A and B,
CY₁ to CY₄ are each independently a C₅-C₆₀ carbocyclic group or a C₁-C₆₀ heterocyclic group,
X₁ is a group including C,
Y₁ is a non-bond, a single bond, O, or S, and
R₁₀ₐ is:
deuterium, -F, -Cl, -Br, -I, a hydroxyl group, a cyano group, or a nitro group;
a C₁-C₆₀ alkyl group, a C₂-C₆₀ alkenyl group, a C₂-C₆₀ alkynyl group, or a C₁-C₆₀ alkoxy group, each unsubstituted or substituted with deuterium, -F, -Cl, -Br, -I, a hydroxyl group, a cyano group, a nitro group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₁₁)(Q₁₂)(Q₁₃), -N(Q₁₁)(Q₁₂), -B(Q₁₁)(Q₁₂), - C(=O)(Q₁₁), -S(=O)₂(Q₁₁), -P(=O)(Q₁₁)(Q₁₂), or any combination thereof;
a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, or a C₂-C₆₀ heteroaryl alkyl group, each unsubstituted or substituted with deuterium, -F, -Cl, -Br, -I, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, a C₁-C₆₀ heterocyclic group, a C₆-C₆₀ aryloxy group, a C₆-C₆₀ arylthio group, a C₇-C₆₀ aryl alkyl group, a C₂-C₆₀ heteroaryl alkyl group, -Si(Q₂₁)(Q₂₂)(Q₂₃), -N(Q₂₁)(Q₂₂), -B(Q₂₁)(Q₂₂), -C(=O)(Q₂₁), - S(=O)₂(Q₂₁), -P(=O)(Q₂₁)(Q₂₂), or any combination thereof; or
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), or - P(=O)(Q₃₁)(Q₃₂),
wherein Q₁ to Q₃, Q₁₁ to Q₁₃, Q₂₁ to Q₂₃, and Q₃₁ to Q₃₃ are each independently: hydrogen; deuterium; -F; -Cl; -Br; -I; a hydroxyl group; a cyano group; a nitro group; a C₁-C₆₀ alkyl group, a C₂-C₆₀ alkenyl group, a C₂-C₆₀ alkynyl group, a C₁-C₆₀ alkoxy group, a C₃-C₆₀ carbocyclic group, or a C₁-C₆₀ heterocyclic group, each unsubstituted or substituted with deuterium, -F, a cyano group, a C₁-C₆₀ alkyl group, a C₁-C₆₀ alkoxy group, C₃-C₆₀ carbocyclic group, a C₁-C₆₀ heterocyclic group, a biphenyl group, or any combination thereof; a C₇-C₆₀ arylalkyl group; or a C₂-C₆₀ heteroarylalkyl group.

9. The light-emitting device of claim 8, wherein:
(i) in Formula 2, Ar₂₁ is a group represented by Formula A-1-4 or a group represented by Formula B-1-1, and Ar₂₂ is a group represented by Formula A-1-4 or a group represented by Formula B-1-1: 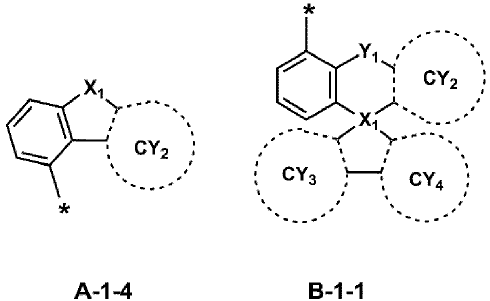 wherein, in Formulae A-1-4 and B-1-1,
CY₂ to CY₄, X₁, and Y₁ are each the same as described in claim 8, and
* indicates a binding site to a neighboring atom; and/or
(ii) the first amine-based compound and the second amine-based compound satisfy one selected from Conditions 2-1 to 2-3:
Condition 2-1
Ar₁₂ is the group represented by Formula A or the group represented by Formula B;
Condition 2-2
Ar₂₂ is the group represented by Formula A or the group represented by Formula B; and
Condition 2-3
Ar₁₂ and Ar₂₂ are each the group represented by Formula A or the group represented by Formula B.

10. The light-emitting device of claim 8 or claim 9, wherein the group represented by Formula A is a group represented by Formula A-1, and
the group represented by Formula B is a group represented by Formula B-1: 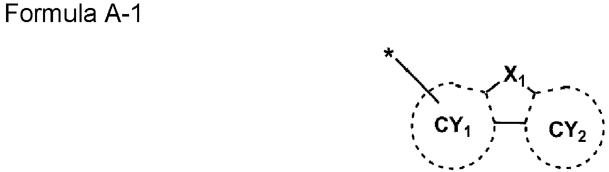 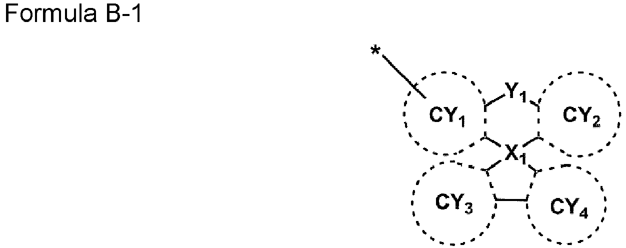 wherein, in Formulae A-1 and B-1,
CY₁ to CY₄, X₁, and Y₁ are each the same as described in claim 8, and
* indicates a binding site to a neighboring atom.

11. The light-emitting device of any one of claims 8 to 10, wherein:
(i) the group represented by Formula A is a group represented by one selected from Formulae A-1-1 to A-1-4, and
the group represented by Formula B is a group represented by one selected from Formulae B-1-1 to B-1-4: 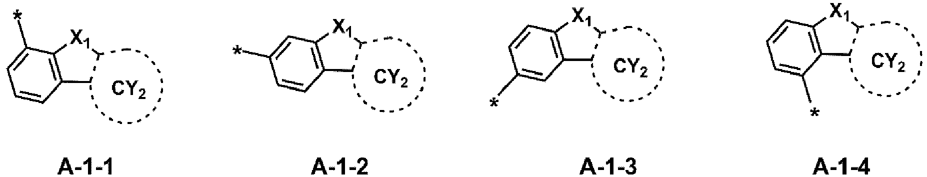 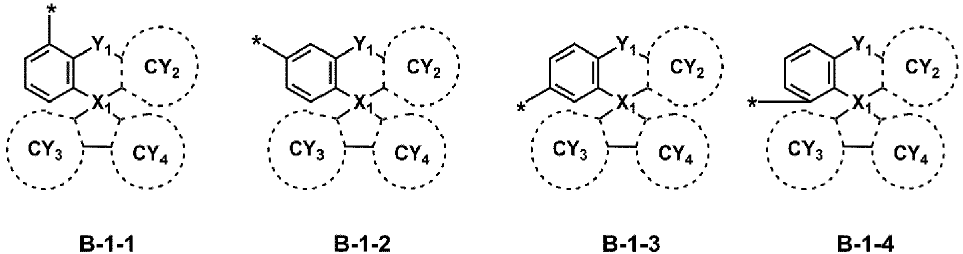 wherein, in Formulae A-1-1 to A-1-4 and B-1-1 to B-1-4,
CY₂ to CY₄, X₁, and Y₁ are each the same as described in claim 8, and
* indicates a binding site to a neighboring atom; and/or
(ii) in Formula 1, L₁₃ is a C₅-C₆₀ carbocyclic group unsubstituted or substituted with at least one R₁₀ₐ,
n13 is 1, and
R₁₀ₐ is the same as described in claim 8.

12. The light-emitting device of any one of claims 8 to 11, wherein:
(i) the first amine-based compound is represented by Formula 1-1: 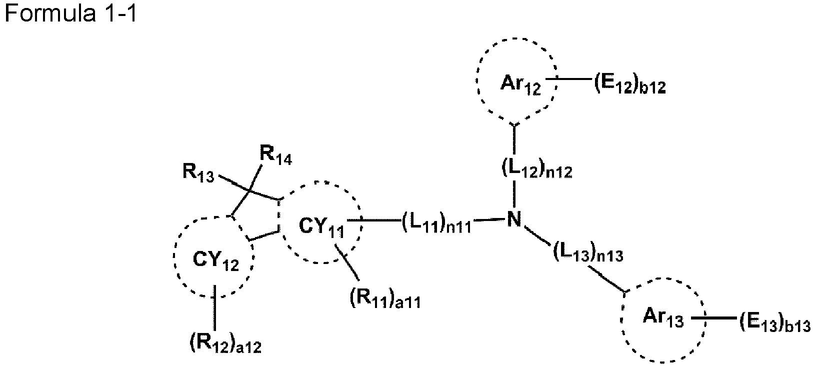 wherein, in Formula 1-1,
CY₁₁ is the same as described in connection with CY₁ in claim 8,
CY₁₂ is the same as described in connection with CY₂ in claim 8,
R₁₁ to R₁₄ are each the same as described in connection with E₁₁ in claim 8,
a11 is an integer selected from 0 to 10,
a12 is an integer selected from 0 to 10, and
Ar₁₂, Ar₁₃, L₁₁ to L₁₃, n11 to n13, E₁₂, E₁₃, b12, and b13 are each the same as described in claim 8; and/or
(ii) the second amine-based compound is represented by Formula 2-1: 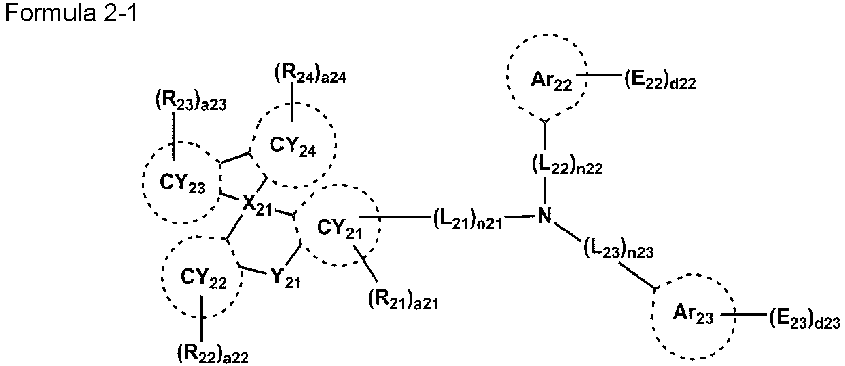 wherein, in Formula 2-1,
X₂₁ is C,
CY₂₁ is the same as described in connection with CY₁ in claim 8,
CY₂₂ is the same as described in connection with CY₂ in claim 8,
CY₂₃ is the same as described in connection with CY₃ in claim 8,
CY₂₄ is the same as described in connection with CY₄ in claim 8,
Y₂₁ is the same as described in connection with Y₁ in claim 8,
R₂₁ to R₂₄ are each the same as described in connection with E₂₁ in claim 8,
a21 to a24 are each independently an integer selected from 0 to 10, and
Ar₂₂, Ar₂₃, L₂₁ to L₂₃, n21 to n23, E₂₂, E₂₃, d22, and d23 are each the same as described in claim 8.

13. The light-emitting device of any one of claims 6 to 12, wherein Y₁ is a single bond.

14. The light-emitting device of claim 1, wherein the first amine-based compound and the second amine-based compound are each one selected from Compounds 1-1 to 1-4 and 2-1 to 2-2:

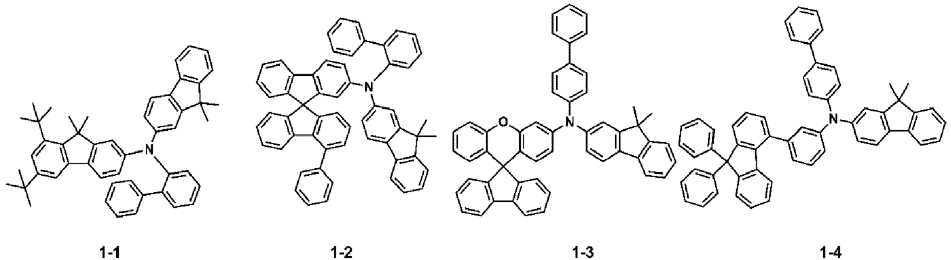

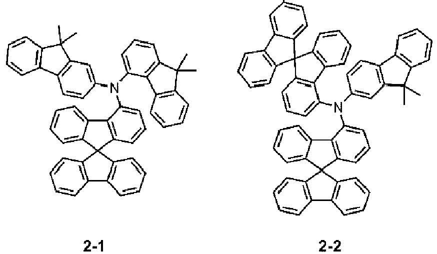

15. An electronic apparatus comprising the light-emitting device of any one of claims 1 to 14.
